(19) Europäisches Patentamt
European Patent Office
Office européen des brevets

(11) **EP 4 189 407 B1**

(12) **EUROPÄISCHE PATENTSCHRIFT**

(45) Veröffentlichungstag und Bekanntmachung des Hinweises auf die Patenterteilung:
**17.07.2024 Patentblatt 2024/29**

(21) Anmeldenummer: **21758652.8**

(22) Anmeldetag: **09.08.2021**

(51) Internationale Patentklassifikation (IPC):
***G01R 19/25*** *(2006.01)*

(52) Gemeinsame Patentklassifikation (CPC):
**G01R 19/2513**

(86) Internationale Anmeldenummer:
**PCT/EP2021/072132**

(87) Internationale Veröffentlichungsnummer:
**WO 2022/048863 (10.03.2022 Gazette 2022/10)**

(54) **VORRICHTUNG, SYSTEM UND VERFAHREN ZUR BESTIMMUNG VON FEHLERSIGNALFENSTERN IN EINEM MESSSIGNAL**

DEVICE, SYSTEM AND METHOD FOR DETERMINING ERROR SIGNAL WINDOWS IN A MEASUREMENT SIGNAL

DISPOSITIF, SYSTÈME ET PROCÉDÉ POUR DÉTERMINER DES FENÊTRES DE SIGNAL D'ERREUR DANS UN SIGNAL DE MESURE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **01.09.2020 DE 102020122792**

(43) Veröffentlichungstag der Anmeldung:
**07.06.2023 Patentblatt 2023/23**

(73) Patentinhaber: **Maschinenfabrik Reinhausen GmbH**
**93059 Regensburg (DE)**

(72) Erfinder:
• **WINKELMANN, Erik**
**01099 Dresden (DE)**
• **STEINER, Christoph**
**01458 Ottendorf-Okrilla (DE)**

(56) Entgegenhaltungen:
**CN-A- 106 160 944    US-B2- 9 305 077**

**Beschreibung**

Elektrische Betriebsmittel können zur Übertragung von elektrischer Energie ausgebildet sein. Das elektrische Betriebsmittel kann beispielsweis ein elektrisches Kabel mit mehreren Leitungen sein, das zur Übertragung von elektrischer Energie dient. Andere elektrische Betriebsmittel, können ebenfalls zur Übertragung von elektrischer Energie verwendet werden, wie beispielsweise Transformatoren, oder auch zur Quantifizierung von Strom und Spannung eingesetzt werden, wie beispielsweise elektrische Wandler oder Freileitungen. Vorzugsweise ist das elektrische Betriebsmittel ein Kabel zur Hochspannungsgleichstromübertragung oder zur Hochspannungswechselstromübertragung. Wird zur elektrischen Energieübertragung eine hohe Spannung verwendet, kann es zu einer Teilentladung (kurz: TE) kommen. Als Teilentladung wird eine örtlich beschränkte elektrische Entladung bezeichnet, welche eine Isolierung zwischen Leitern, insbesondere des zuvor genannten Kabels, teilweise überbrückt. Teilentladungen können beispielsweise durch Fehlstellen in dem Leiter und/oder durch Inhomogenitäten in der Isolierung der Kabel auftreten. Findet eine Teilentladung statt, verursacht dies ein die Teilentladung repräsentierendes Signal mit einem zugehörigen Signalmuster, das von dem elektrischen Betriebsmittel ebenfalls übertragen wird. Die Übertragung findet in diesem Fall jedoch von dem Ort der Teilentladung zu einer Anschlussstelle des Betriebsmittels statt. Das von der Teilentladung hervorgerufene Signal muss also einen gewissen Übertragungsweg zurücklegen, bevor das von der Teilentladung hervorgerufene Signal an der Anschlussstelle des elektrischen Betriebsmittels erfasst werden kann. Induktive, kapazitive und/oder resistive Elemente des elektrischen Betriebsmittels können eine Dämpfung und/oder Verformung des von der Teilentladung hervorgerufenen Signals verursachen. An der Anschlussstelle kann deshalb oftmals nur ein gedämpftes und/oder verformtes Signal sensorisch erfasst werden, das von der Teilentladung verursacht ist. Das von der Teilentladung verursachte Signal kann auch als Fehlersignalkomponente eines Messsignals oder kurz als Fehlersignal bezeichnet sein. Andere Fehlersignale können auch durch andere Fehler des elektrischen Betriebsmittels verursacht sein.

Um festzustellen, ob ein Fehler bei der elektrischen Energieübertragung mittels eines elektrischen Betriebsmittels aufgetreten ist, wird in der Praxis oftmals ein an eine Anschlussstelle des elektrischen Betriebsmittels erfassbares Messsignal aufgezeichnet und anschließend manuell, beispielsweise mit einem Oszilloskop, untersucht, um festzustellen, ob ein Fehler bei der elektrischen Energieübertragung in dem elektrischen Betriebsmittel aufgetreten ist. Diese Vorgehensweise ist jedoch nicht robust gegenüber möglichen Fehleinschätzungen und außerdem sehr zeitaufwändig. Dokument US9305077 offenbart ein Computerprogrammprodukt zum Verarbeiten eines Stroms von Tupeln zum Verwalten mehrerer Fenster auf einem Operatorgraphen, mit einer Anweisung zum Einfügen eines Tupels in ein Untergruppierungsfenster als Reaktion auf eine erfüllte Untermitgliedschaftsbedingung

Dokument CN106160944 offenbart ein Ultraschall-Teilentladungssignal-Kodierungskompressionsverfahren mit variabler Rate, das die Durchführung eines Rahmenteilungsprozesses beinhaltet, um ein Mehrrahmensignal zu erhalten, und das die Kodierungsrate jedes Rahmensignals entsprechend dem Typ des Rahmensignals erhält.

Der Erfindung liegt die Aufgabe zugrunde, eine Vorrichtung, ein System und ein Verfahren bereitzustellen, das eine effiziente und fehlerrobuste Erkennung von Fehlern bei der elektrischen Energieübertragung mittels eines elektrischen Betriebsmittels erlaubt.

Gemäß einem ersten Aspekt der Erfindung wird die genannte Aufgabe gelöst durch eine Vorrichtung mit den Merkmalen des Anspruchs 1. Vorgesehen ist also eine Vorrichtung mit einer Eingangssignalschnittstelle zum Empfang eines digitalen Messsignals, das ein an einer Anschlussstelle eines elektrischen Betriebsmittel erfasstes, analoges Signal repräsentiert. Das digitale Messsignal ist eine Folge von Abtastwerten des erfassten Signals. Außerdem weist die Vorrichtung eine Prozessoreinheit auf, die konfiguriert ist, jedem Abtastwert des Messsignals jeweils ein Signalfenster zuzuordnen, das jeweils aus einem Teil der Folge von Abtastwerten des Messsignals mit dem jeweiligen Abtastwert und einer vorbestimmten Anzahl von zeitlich vorhergehenden Abtastwerten des Messsignals gebildet ist. Die Prozessoreinheit ist konfiguriert, in einer Initialisierungsphase eine Anzahl von M Signalfenstern als Initialisierungsfenster und aus diesen M Initialisierungsfenstern eine Anzahl von K Rauschfenstern zu bestimmen, jedes Rauschfenster mittels eines vorbestimmten Modells X'ter Ordnung zu analysieren und die zugehörigen Koeffizienten zu ermitteln, die ein dem jeweiligen Rauschfenster zugeordnetes Initialkoeffiziententupel bilden, und aus den Initialkoeffiziententupel der Rauschfenster einen Erwartungswert als Rauschtupel zu ermitteln, wobei X eine gerade Zahl zwischen eins und fünf ist. Außerdem ist die Prozessoreinheit konfiguriert, in einer Untersuchungsphase eine Vielzahl der Signalfenster als Messfenster zu bestimmen, jedes Messfenster mittels des vorbestimmten Modells X'ter Ordnung zu analysieren und die zugehörigen Koeffizienten zu ermitteln, die ein dem jeweiligen Messfenster zugeordnetes Messtupel bilden, zu jedem Messfenster eine Distanz des zugehörigen Messtupels zu dem Rauschtupel zu ermitteln, und aus der Vielzahl der Messfenster die Messfenster als Fehlersignalfenster zu bestimmen, deren zugehöriges Messtupel jeweils eine Distanz zum Rauschtupel aufweisen, die größer als ein erster, vorbestimmter Grenzwert ist. Daraus folgt, dass jedes Fehlersignalfenster einen Signalfehler des Messsignals repräsentiert. Der Signalfehler kann dabei eine Fehlersignalkomponente des Messsignals sein.

Wird mittels des elektrischen Betriebsmittels elektrische Energie übertragen, kann an der Anschlussstelle ein Signal erfasst werden, das die bei der Energieübertragung auftretende elektrische Spannung, die bei der Energieübertragung auftretende elektrische Leistung, den bei der Energieübertragung auftretenden elektrischen Strom und/oder einen anderen die elektrische Energieübertragung repräsentierenden Wert angibt. Das erfasste Signal repräsentiert vorzugsweise den zeitlichen Verlauf der mittels des elektrischen Systems übertragenen Energie, des zugehörigen Stroms, der zugehörigen Spannung und/oder der zugehörigen Leistung. Das digitale Messsignal, das der Eingangssignalschnittstelle der Vorrichtung zur Verfügung gestellt wird, repräsentiert das an der Anschlussstelle des elektrischen Betriebsmittels erfasste Signal. Das digitale Messsignal ist von einer Folge von Abtastwerten des erfassten Signals gebildet. Das digitale Messsignal wird kurz als Messsignal bezeichnet.

Oftmals repräsentiert das Messsignal jedoch nicht nur die von dem elektrischen Betriebsmittel übertragene elektrische Energie (bzw. zugehörigen Strom, zugehörige Spannung und/oder zugehörige Leistung), sondern auch ein durch die Umgebung hervorgerufenes Rauschen sowie Fehlersignale, die durch Fehler bei der Energieübertragung mittels des elektrischen Betriebsmittels auftreten können.

Für die Konfiguration der Prozessoreinheit der Vorrichtung wird von dem Grundgedanken ausgegangen, dass sich das Rauschen von der Fehlersignalkomponente des Messsignals unterscheidet, die durch einen Fehler bei der Energieübertragung mittels des elektrischen Betriebsmittels verursacht ist. In einer Initialisierungsphase soll deshalb zunächst mittels eines mathematischen Modells ein Initialkoeffiziententupel ermittelt werden, das charakteristisch für das bei der Energieübertragung auftretende Rauschen ist. Das Modell dient zur Modellierung der Übertragungsfunktion bzw. des Übertragungsweges des elektrischen Betriebsmittels bei der Energieübertragung. Je nach Anpassung der Koeffizienten kann das Modell auf die jeweilige Übertragungseigenschaften des elektrischen Betriebsmittels angepasst werden. Die Prozessoreinheit ist vorzugsweise konfiguriert, um die Koeffizienten des Modells basierend auf einem Signalfenster derart anzupassen, dass das Modell die tatsächliche Übertragungsfunktion des elektrischen Betriebsmittels möglichst genau annähert.

Die Prozessoreinheit ist außerdem konfiguriert, in der Initialisierungsphase eine Anzahl von M Signalfenster als Initialisierungsfenster zu bestimmen. Diese M Signalfenster sind dabei vorzugsweise einer entsprechenden Anzahl von M Abtastwerten zugeordnet. Diese M Abtastwerte sind vorzugsweise M aufeinander folgende Abtastwerte des Messsignals. Das Messsignal kann eine Nutzkomponente, eine Fehlersignalkomponente und eine Rauschkomponente aufweisen. Die Nutzkomponente repräsentiert dabei die elektrische Energieübertragung, die zugehörige Spannung, den zugehörigen Strom und/oder die zugehörige Leistung während der elektrischen Energieübertragung. Die Fehlersignalkomponente kann durch mögliche Fehler bei der elektrischen Energieübertragung verursacht sein und die Rauschkomponente kann das bei der elektrischen Energieübertragung und/oder messtechnische Erfassen des Messsignals auftretende Rauschen repräsentieren. Die Prozessoreinheit ist deshalb bevorzugt konfiguriert, um aus den M Initialisierungsfenstern eine Anzahl von K Rauschfenstern zu bestimmen. Die Prozessoreinheit kann dazu beispielsweise jedes der M Initialisierungsfenster in Bezug auf das zugehörige Spektrum, eine Signalenergie des von dem jeweiligen Initialisierungsfenster repräsentierten Teils des Messsignals, die Anzahl der Nulldurchgänge des von dem jeweiligen Initialisierungsfenster repräsentierten Teils des Messsignals und/oder andere Analyseparameter bestimmen, sodass beispielsweise anhand des Spektrums, der Signalenergie, der Anzahl der Nulldurchgänge und/oder der Analyseparameter von der Prozessoreinheit bestimmt wird, welche der M Initialisierungsfenster als Rauschfenster zu werten sind. Auf diese Weise kann die Prozessoreinheit beispielsweise die K Rauschfenster bestimmen. Bei jedem der Rauschfenster wird angenommen, das die jeweilige Rauschkomponente besonders groß bzw. dominant ist.

Die Prozessoreinheit ist konfiguriert, jedes Rauschfenster mittels eines vorbestimmten Modells X'ter Ordnung zu analysieren und dadurch die zugehörigen Koeffizienten zu ermitteln. Bei den Koeffizienten handelt es sich deshalb um die Koeffizienten des vorbestimmten Modells. Die Koeffizienten können auch als Modellkoeffizienten bezeichnet sein. Bei dem Modell handelt es sich vorzugsweise um ein mathematisches Modell. Das Modell kann dazu ausgebildet sein, um durch Anpassung der zugehörigen Koeffizienten das von einem Signalfenster gebildete Teilsignal zu repräsentieren. Durch die von der Prozessoreinheit für jedes Rauschfenster ausgeführte Analyse wird das Modell durch die Anpassung der zugehörigen Koeffizienten jeweils derart angepasst, um das von dem jeweiligen Rauschfenster repräsentierte Teilsignal möglichst genau zu repräsentieren. Vorzugsweise ist X die gerade Zahl 2. Dadurch ist es besonders effizient und schnell möglich, jedes Rauschfenster bzw. jedes von einem Rauschfenster repräsentierte Teilsignal mittels des vorbestimmten Modells derart zu analysieren, um die zugehörigen Koeffizienten des Modells zu ermitteln. Dadurch werden jedem Rauschfenster Koeffizienten zugeordnet, die gemeinsam je Rauschfenster als Initialkoeffiziententupel bezeichnet werden. Somit ist jedem Rauschfenster genau ein dediziertes Initialkoeffiziententupel zugeordnet.

Die Prozessoreinheit ist konfiguriert, aus der entsprechenden Anzahl von K Initialkoeffiziententupeln einen Erwartungswert als Rauschtupel zu ermitteln. Das Rauschtupel kann dabei der arithmetische Mittelwert der Initialkoeffiziententupel sein. Ist jedes Initialkoeffiziententupel durch einen Vektor von mehreren Koeffizienten gebildet, so kann das Rauschtupel beispielsweise durch Addition der entsprechenden Vektoren und durch anschließende Teilung des Ergebnisses durch die Anzahl der Initialkoeffiziententupel ermittelt werden. Hierzu kann die Prozessoreinheit ausgebildet sein. Das Rauschtupel kann somit den Erwartungswert für die Initialkoeffiziententupel bilden. Das Rauschtupel kann auch als Rauschzentrum für die Initialkoeffiziententupel verstanden werden. Denn die Initialkoeffiziententupel liegen im geometrischen Raum um das Rauschtupel herum verteilt angeordnet.

In der Initialisierungsphase werden von der Prozessoreinheit eine Anzahl von M Signalfenstern als Initialisierungsfenster bestimmt. Auf die Initialisierungsphase folgt die Untersuchungsphase. Die Prozessoreinheit ist deshalb konfiguriert, in der Untersuchungsphase eine Vielzahl der Signalfenster als Messfenster zu bestimmen. Vorzugsweise unterscheiden sich die Messfenster von den Signalfenstern, die zuvor in der Initialisierungsphase bestimmt worden sind. Die Vielzahl der Messfenster ist vorzugsweise deutlich größer als die Anzahl der Initialisierungsfenster. Ein Grundgedanke der Erfindung ist es, in der Untersuchungsphase mehrere der Messfenster als Fehlersignalfenster zu identifizieren, die jeweils einen Signalfehler in dem von dem jeweiligen Signalfenster repräsentierten Teil des Messsignals repräsentieren. Es ist deshalb sinnvoll, dass die Anzahl der Messfenster deutlich größer als die Anzahl der Initialisierungsfenster ist.

Die Prozessoreinheit ist konfiguriert, in der Untersuchungsphase jedes Messfenster mittels des vorbestimmten Modells X'ter Ordnung zu analysieren, um die zugehörigen Koeffizienten zu ermitteln. Somit wird jedes Messfenster mittels des gleichen vorbestimmten Modells X'ter Ordnung analysiert, das auch schon zur Analyse der Rauschfenster in der Initialisierungsphase verwendet wurde. Die Analyse der Messfenster kann somit analog zu der Analyse der Rauschfenster mittels der Prozessoreinheit ausgeführt werden. Jedes Messfenster wird von der Prozessoreinheit deshalb derart mittels des Modells X'ter Ordnung analysiert, sodass die zugehörigen Koeffizienten des Modells ermittelt werden. Die für jedes Messfenster ermittelten Koeffizienten werden als Messtupel bezeichnet und sind dem jeweiligen Messfenster zugeordnet. Ist das vorbestimmte Modell von zweiter Ordnung, so werden auch jeweils zwei Koeffizienten je Messfenster ermittelt. Ist das Modell jedoch höherer Ordnung, so wird eine der Ordnung entsprechende Anzahl an Koeffizienten je Messfenster ermittelt. Ist ein Messtupel für ein Messfenster ermittelt, so weist das Messtupel im geometrischen Raum eine bestimmte Distanz zu dem Rauschtupel auf, das in der Initialisierungsphase ermittelt wurde. Eine Dimension des geometrischen Raums kann der Ordnung des Modells entsprechen. Ist das vorbestimmte Modell höherer Ordnung, insbesondere dritter, vierter oder fünfter Ordnung, so kann die Distanz eine in dem entsprechenden Raum definierte Distanz sein. Die Prozessoreinheit ist konfiguriert, zu jedem Messwert eine zugehörige Distanz des jeweiligen Messtupels zu dem Rauschtupel zu ermitteln. Somit werden entsprechend der Anzahl der Messfenster eine entsprechende Anzahl von Messtupel und eine entsprechende Anzahl von Distanzen mittels der Prozessoreinheit ermittelt. Weist ein Messtupel eine geringe Distanz zu dem Rauschtupel auf, so wird das zugehörige Messfenster sehr wahrscheinlich einen Teil des Messsignals mit einem großen Rauschanteil repräsentieren. Ist die Distanz zwischen dem Messtupel und dem Rauschtupel jedoch größer, insbesondere größer als ein erster, vorbestimmter Grenzwert, so wird das zugeordnete Messfenster sehr wahrscheinlich einen Teil des Messsignals mit einem Signalfehler repräsentieren. Denn der Signalfehler verursacht bei der Analyse dieses Messfensters, das für das vorbestimmte Modell andere Koeffizienten ermittelt werden, sodass das jeweilige daraus entstehende Messtupel in einer größeren Distanz zu dem Rauschtupel angeordnet ist. Durch die jeweilige Distanz zwischen einem Messtupel und einem Rauschtupel können somit sehr effektiv aus der Vielzahl der Messfenster diejenigen Messfenster als Fehlersignalfenster bestimmt werden, die einen Signalfehler des Messsignals repräsentieren.

Basierend auf den vorangegangenen Erläuterungen ist es deshalb für die Prozessoreinheit vorgesehen, dass die Prozessoreinheit konfiguriert ist, zu jedem Messfenster eine Distanz des zugehörigen Messtupels zu dem Rauschtupel zu ermitteln und aus der Vielzahl der Messfenster diejenigen Messfenster als Fehlersignalfenster zu bestimmen, deren zugehöriges Messtupel jeweils eine Distanz zum Rauschtupel aufweisen, die größer als ein erster, vorbestimmter Grenzwert ist. Dadurch wird gewährleistet, dass jedes Fehlersignalfenster einen Teil des Messsignals mit einem Signalfehler repräsentiert. Folglich repräsentiert jedes Fehlersignalfenster auch einen Signalfehler des Messsignals.

Die zuletzt genannte Konfiguration der Prozessoreinheit zur Bestimmung der Fehlersignalfenster erlaubt eine schnelle und robuste Bestimmung der Fehlersignalfenster, in denen Signalfehler zu erwarten sind. Für eine weitergehende Analyse können diese Fehlersignalfenster weiter ausgewertet werden. In einer weiteren Analyse kann insbesondere die Art und die Güte der Signalfehler und/oder die Art und/oder Güte der Fehler bestimmt werden, die bei der Energieübertragung mittels des elektrischen Betriebsmittels aufgetreten sind. Die Prozessoreinheit kann dazu entsprechend konfiguriert sein.

Die Konfiguration der Prozessoreinheit bietet darüber hinaus den Vorteil, dass auf die manuelle Analyse des gesamten Messsignals verzichtet werden kann. Vielmehr ist es durch die Konfiguration der Prozessoreinheit möglich, dass eine weitere Aufwertung auf bestimmte Abschnitte, nämlich die Fehlersignalfenster des Messsignals konzentriert werden kann. Der Gesamtaufwand zur Fehlererkennung und/oder Analyse bei der Energieübertragung kann dadurch auf einen Bruchteil reduziert werden.

Zuvor wurde bereits erläutert, dass die Prozessoreinheit konfiguriert ist, jedem Abtastwert des Messsignals jeweils ein Signalfenster zuzuordnen. Dadurch entsteht eine Vielzahl von Signalfenstern. Es wird auch davon gesprochen, dass sich dadurch ein Ablauf von Signalfenstern ergibt, der sich von Abtastwert zu Abtastwert mitbewegt. Jedes Signalfenster kann beispielsweise mindestens 16, mindestens 32 oder mindestens 64 Abtastwerte umfassen. Bevorzugt weist jedes Signalfenster beispielsweise 128 Abtastwerte auf. Die Initialphase kann sehr kurz sein. Die Prozessoreinheit kann vorzugsweise dazu ausgebildet sein, um nach jeder Initialisierungsphase eine Untersuchungsphase auszuführen. Die Anzahl der Messfenster kann deutlich größer als die Anzahl der Initialisierungsfenster sein. So kann die Anzahl der Messfenster beispielsweise mindestens das Zehnfache der Anzahl der Initialisierungsfenster sein. Die Prozessoreinheit kann außerdem dazu konfiguriert sein, die Initialisierungsphase mindestens 2 Mal pro Sekunde auszuführen. Entsprechend der Abtastfrequenz kann die Anzahl der Messfenster bestimmt sein. Die Anzahl der Wiederholung der Initialisierungsphase kann auch erhöht sein. So kann die Prozessoreinheit konfiguriert sein, die Initialisierungsphase beispielsweise 2 bis 10 Mal pro Sekunde auszuführen. Eine entsprechende Anpassung der Anzahl der Messfenster kann dazu vorgenommen sein. Außerdem wurde zuvor erläutert, dass das Rauschtupel in dem Zentrum zwischen den Initialkoeffizientetupeln angeordnet sein kann. Somit kann das Rauschtupel im Rauschzentrum einer "Wolke" aus Initialkoeffizientetupeln der Rauschfenster liegen. Vorzugsweise ist die Abtastfrequenz für die Abtastwerte des Messsignals derart gewählt, dass in der Untersuchungsphase vorzugsweise mindestens 10.000 Signalfenster zu Messfenstern bestimmt sind. Vorzugsweise können es auch noch deutlich mehr sein.

Außerdem wurde zuvor erläutert, dass die Prozessoreinheit konfiguriert ist, zu jedem Messfenster eine Distanz des zugehörigen Messtupels zu dem Rauschtupel zu ermitteln. Die Distanz zwischen einem jeweiligen Messtupel und dem Rauschtupel ist vorzugsweise die Mahalanobis-Distanz zwischen dem jeweiligen Messtupel und dem Rauschtupel. Zu der Ermittlung der Mahalanobis-Distanz wird auf die folgende Veröffentlichung Bezug genommen: N-Dimensional cumulative function, and other useful facts about gaussians and normal densities von Michaël Bensimhoun (Jerusalem, 06/2009).

Das vorbestimmte Modell X'ter Ordnung kann ein lineares Modell und/oder ein LPC-Modell entsprechender Ordnung sein. Die zum Modell X'ter Ordnung zugehörigen Koeffizienten können beispielsweise $\alpha$-Koeffizienten, PARCOR-Koeffizienten, oder Prediction Error Koeffizienten und/oder normalisierte Fehler sein.

Zuvor wurde außerdem erläutert, dass die Prozessoreinheit konfiguriert ist, aus der Vielzahl der Messfenster ein Messfenster jeweils dann als Fehlersignalfenster zu bestimmen, wenn das zugehörige Messtupel eine Distanz zum Rauschtupel aufweist, die größer als ein erster, vorbestimmter Grenzwert ist. Dieser Grenzwert kann beispielsweise das Einfache bis Fünffache einer Standardabweichung zum Erwartungswert bzw. Rauschtupel sein. Der vorbestimmte Grenzwert kann beispielsweise basierend auf Fachwissen und vorherigen Testungen vorbestimmt sein. Andere Möglichkeiten zur Vorbestimmung des Grenzwertes sind ebenfalls möglich.

Eine vorteilhafte Ausgestaltung der Vorrichtung zeichnet sich dadurch aus, dass die Prozessoreinheit konfiguriert ist, zu jedem Initialisierungsfenster die zugehörige Anzahl der Nulldurchgänge des von dem jeweiligen Initialisierungsfenster repräsentierten Teils des Messsignals zu ermitteln. Außerdem ist die Prozessoreinheit bevorzugt derart konfiguriert, aus den Initialisierungsfenstern die Anzahl von K Initialisierungsfenstern mit den meisten Nulldurchgängen als die Rauschfenster zu bestimmen. In der Praxis wurde festgestellt, dass eine hohe Anzahl von Nulldurchgängen bei einem von einem Initialisierungsfenster repräsentierten Teil des Messsignals daraufhin deuten, dass dieser Teil des Messsignals sehr verrauscht ist. Um unter den Initialisierungsfenstern die Rauschfenster mit dem meisten Rauschen zu ermitteln, hat sich die Ermittlung der Anzahl der Nulldurchgänge für die Initialisierungsfenster als eine effiziente Methode herausgestellt. Ein Nulldurchgang von einem Messsignal liegt vorzugsweise dann vor, wenn der Wert des Messsignals den Wert Null oder einen anderen vorbestimmten Signalwert vorzugsweise kurzfristig erreicht oder durchläuft. Die Anzahl K der Rauschfenster ist vorzugsweise kleiner, insbesondere deutlich kleiner, als die Anzahl M der Initialisierungsfenster. So kann die Anzahl K beispielsweise höchstens zwei Drittel, höchstens die Hälfte oder höchstens ein Drittel der Anzahl M sein. Dadurch kann besonders robust festgelegt werden, welche der Initialisierungsfenster als Rauschfenster von der Prozessoreinheit bestimmt werden. Diese Rauschfenster werden in der Initialisierungsphase dazu verwendet, um eine entsprechende Anzahl von K Initialkoeffizientetupel und hieraus das Rauschtupel zu ermitteln. Bekanntlich erlaubt Rauschen keine sinnvolle Korrelation. Deshalb ist die Verwendung der Nulldurchgänge und die robuste Festlegung der Rauschfenster eine effiziente und zugleich robuste Möglichkeit, das Rauschtupel festzulegen, sodass zu jedem Messfenster in der Untersuchungsphase eine Distanz des zugehörigen Messtupels zum Rauschtupel ermittelbar ist. Dies wiederum erlaubt die Feststellung der Fehlersignalfenster. Darüber hinaus bietet die Möglichkeit der Bestimmung der Rauschfenster unter Zuhilfenahme der Ermittlung der Nulldurchgänge, dass die Rauschfenster in Echtzeit bzw. zeitparallel während der Initialisierungsphase und/oder vor Beginn der Untersuchungsphase ermittelbar sind.

Eine weitere vorteilhafte Ausgestaltung der Vorrichtung zeichnet sich dadurch aus, dass die Prozessoreinheit dazu konfiguriert ist, zu jedem Initialisierungsfenster eine zugehörige Signalenergie des von dem jeweiligen Initialisierungsfenster repräsentierten Teils des Messsignals zu ermitteln, wobei die Prozessoreinheit außerdem konfiguriert ist, aus den Initialisierungsfenstern die Anzahl von K Initialisierungsfenstern mit den kleinsten Signalenergien als die Rauschfenster zu bestimmen. Denn in der Praxis wurde auch festgestellt, dass eine kleine Signalenergie bei einem von einem Initialisierungsfenster repräsentierten Teil des Messsignals daraufhin deutet, dass dieser Teil des Messsignals sehr verrauscht ist. Um unter den Initialisierungsfenstern die Rauschfenster mit dem meisten Rauschen zu ermitteln, hat sich die Ermittlung der kleinsten Signalenergie für die Initialisierungsfenster als eine ebenfalls effiziente Methode herausgestellt. Somit können die Rauschfenster anstatt mithilfe der Nulldurchgänge auch mithilfe der Signalenergien bestimmt werden. Dadurch kann ebenfalls besonders robust festgelegt werden, welche der Initialisierungsfenster als Rauschfenster von der Prozessoreinheit bestimmt werden. Diese Rauschfenster werden in der Initialisierungsphase dazu verwendet, um eine entsprechende Anzahl von K Initialkoeffizientetupel und hieraus das Rauschtupel zu ermitteln. Bekanntlich erlaubt Rauschen keine sinnvolle Korrelation. Deshalb ist die Verwendung der kleinsten Signalenergie und die robuste Festlegung der Rauschfenster eine effiziente und zugleich robuste Möglichkeit, das Rauschtupel festzulegen, sodass zu jedem Messfenster in der Untersuchungsphase eine Distanz des zugehörigen Messtupels zum Rauschtupel ermittelbar ist. Dies wiederum erlaubt die Feststellung der Fehlersignalfenster. Darüber hinaus bietet die Möglichkeit der Bestimmung der Rauschfenster unter Zuhilfenahme der Ermittlung der kleinsten Signalenergie, dass die Rauschfenster in Echtzeit bzw. zeitparallel während der Initialisierungsphase und/oder vor Beginn der Untersuchungsphase ermittelbar sind.

Anstatt der Signalenergie kann auch die sogenannte "spectral flatness" verwendet werden. Die Prozessoreinheit kann dazu entsprechend konfiguriert sein.

Eine weitere vorteilhafte Ausgestaltung der Vorrichtung zeichnet sich dadurch aus, dass das Modell X'ter Ordnung als ein LPC-Modell X'ter Ordnung ausgebildet ist. LPC-Modelle sind grundsätzlich aus dem Stand der Technik bekannt. Das LPC-Modell kann beispielsweise mittels der folgenden Rekursionsgleichung beschrieben sein:

$$y(k) = e(k) + \Sigma_1^N a_i \cdot y(k - i) \, .$$

Dabei ist k eine diskrete Zeitvariable, also eine natürliche Zahl größer null, y(k) ist der Wert des diskreten Messsignals zum diskreten Zeitpunkt k und N ist eine Ordnung der Approximation, wobei N dem Wert X der X'ten Ordnung des LPC-Modells entspricht. Die $a_i$ sind vorzugsweise die sogenannten linearen Prädiktoren der N-ten Ordnung und e(k) ist ein Vorhersagefehler. Die Prädiktoren $a_i$ bilden vorzugsweise die Koeffizienten des LPC-Modells. Da die Werte des diskreten Messsignals bekannt sind, können die Prädiktoren bzw. die Koeffizienten des Modells mittels der Prozessoreinheit derart bestimmt werden, indem der gesamte quadratische Fehler der Approximation des Modells in Bezug auf das diskrete Messsignal minimiert wird. Dabei wird jeweils der Teil des von dem jeweiligen Fenster repräsentierten Messsignals berücksichtigt. Der gesamte quadratische Fehler kann jeweils angegeben werden durch Q gemäß der folgenden Gleichung:

$$Q = \Sigma_1^N e^2 (k) = \Sigma_1^N (y(k) - \Sigma_1^N a_i \cdot y(k - i))^2 \, .$$

Dazu kann der gesamte quadratische Fehler der Prädiktoren $a_i$ bzw. Koeffizienten differenziert werden, dass jeweilige Ergebnis mit Null gleichgesetzt werden und das resultierende Gleichungssystem aus N linearen Gleichungen gelöst werden. Hierzu kann die Prozessoreinheit entsprechend konfiguriert sein, um die Koeffizienten des LPC-Modells zu ermitteln. Bezüglich des LPC-Modells und der Ermittlung der Koeffizienten wird außerdem auf die Publikation DE 10 2018 126 743 B3 Bezug genommen.

Das Modell X'ter Ordnung ist zwar bevorzugt als ein LPC-Modell X'ter Ordnung ausgebildet. Es kann jedoch auch vorgesehen sein, dass das Modell X'ter Ordnung als ein anderes mathematisches Modell X'ter Ordnung ausgebildet ist. So kann das Modell beispielsweise unter Zuhilfenahme einer Fourier-Transformation oder einer Wavelet-Transformation gebildet sein.

Eine weitere vorteilhafte Ausgestaltung der Vorrichtung zeichnet sich dadurch aus, dass M eine ganze Zahl von mindestens 100, vorzugsweise von mindestens 10.000 ist. Außerdem ist es bevorzugt vorgesehen, dass K eine ganze Zahl ist, die vorzugsweise kleiner als M ist. Vorzugsweise ist K kleiner als das 0,5-fache von M, vorzugsweise ist K maximal das 0,1-fache von M. Dadurch kann eine robuste und einfache Bestimmung der Anzahl der Rauschfenster gewährleistet werden.

Eine weitere vorteilhafte Ausgestaltung der Vorrichtung zeichnet sich dadurch aus, dass jede Initialisierungsphase maximal 0,1 Sekunden, vorzugsweise maximal 0,05 Sekunden dauert. Die Untersuchungsphase kann beispielsweise mehrere Sekunden oder sogar mehrere Minuten oder sogar noch länger dauern. Durch die geringe Dauer der Initialisierungsphase kann besonders schnell in die Untersuchungsphase übergegangen werden. Wenn die Vorrichtung von einem Benutzer verwendet wird, wird der Benutzer im Regelfall die Initialisierungsphase nicht wahrnehmen.

Eine weitere vorteilhafte Ausgestaltung der Vorrichtung zeichnet sich dadurch aus, dass die Prozessoreinheit konfiguriert ist, jedes Fehlersignalfenster mittels eines vorbestimmten Modells N-ter Ordnung zu analysieren und die zugehörigen Koeffizienten zu ermitteln, die ein dem jeweiligen Fehlersignalfenster zugeordnetes Fehlertupel bilden, wobei N eine ganze Zahl von mindestens 6, vorzugsweise 8 ist. Das Analysieren kann während der Untersuchungsphase stattfinden. Vorzugsweise ist das Modell N-ter Ordnung vom gleichen Typ wie das Modell X'ter Ordnung. Beide Modelle, also sowohl das Modell N-ter Ordnung als auch das Modell X'ter Ordnung, können jeweils von einem LPC-Modell in entsprechender Ordnung gebildet sein. Das Modell X'ter Ordnung ist vorzugsweise ein Modell zweiter Ordnung oder ein Modell dritter Ordnung. Das Modell N-ter Ordnung ist vorzugsweise ein Modell sechster Ordnung oder ein Modell einer noch höheren Ordnung, wie beispielsweise achter Ordnung. Die Ordnung kann jedoch auch noch größer sein. Vorzugsweise ist N mindestens 10, 12 oder 14. In der Untersuchungsphase wird mittels der Prozessoreinheit aus der Vielzahl der Messfenster diejenigen Messfenster jeweils ein Fehlersignalfenster bestimmt, deren zugehöriges Messtupel eine Distanz zum Rauschtupel aufweist, die größer als der erste, vorbestimmte Grenzwert ist. Dadurch kann angenommen werden, dass der von dem jeweiligen Fehlersignalfenster repräsentierte Teil des Messsignals einen Signalfehler umfasst. Gemäß der zuletzt genannten, vorteilhaften Ausgestaltung der Vorrichtung ist die Prozessoreinheit konfiguriert, das Fehlersignalfenster mittels des vorbestimmten Modells N-ter Ordnung, also einem Modell von mindestens sechster Ordnung, zu analysieren. Durch die Analyse werden die zugehörigen Koeffizienten ermittelt. Die Analyse kann also derart ausgeführt werden, um die Koeffizienten des Modells der mindestens sechsten Ordnung zu bestimmen. Dadurch kann der von dem Fehlersignalfenster repräsentierte Teil des Messsignals besonders genau untersucht werden. Dies verursacht jedoch bei der Analyse des Fehlersignalfensters mittels des vorbestimmten Modells N-ter Ordnung einen nicht unerheblichen Rechenaufwand. Da jedoch nur eine begrenzte Anzahl von Fehlersignalfenstern bestimmt werden, ist dies oftmals zeitnah und während der Untersuchungsphase möglich. Mit anderen Worten werden nur die Fehlersignalfenster intensiver analysiert. Vorzugsweise können mittels der Koeffizienten die Real- und Imaginärteile der Pole des von dem jeweiligen Fehlersignalfensters repräsentierten Teils des Messsignals mittels der Prozessoreinheit ermittelt werden. Die Prozessoreinheit kann hierzu konfiguriert sein. Aus den Real- und Imaginärteilen kann ermittelt werden, ob der von dem jeweiligen Fehlersignalfenster repräsentierte Teil des Messsignals auf einen Fehler, insbesondere eine Teilentladung, zurückzuführen ist. Durch eine Anpassung des ersten, vorbestimmten Grenzwerts kann es in der Praxis oftmals gewährleistet werden, dass die Fehlersignalfenster ausschließlich oder zu einem großen Anteil Teile des Messsignals repräsentieren, die durch Fehler, und insbesondere Teilentladungen verursachte Signalkomponenten umfassen. Um den Rechenaufwand zur Analyse der Fehlersignalfenster jedoch in einem akzeptablen Niveau zu halten, kann es vorgesehen sein, dass die N-te Ordnung des Modells begrenzt ist. So kann N beispielsweise maximal 20 oder 30 sein.

Eine weitere vorteilhafte Ausgestaltung der Vorrichtung zeichnet sich dadurch aus, dass die Prozessoreinheit konfiguriert ist, die Fehlertupel in mehrere Fehlergruppen aufzuteilen, so dass die Fehlertupel der gleichen Fehlergruppe untereinander jeweils einen Abstand aufweisen, der kleiner als ein zweiter, vorbestimmter Grenzwert ist, so dass alle Fehlersignalfenster, die durch ihre zugehörigen Fehlertupel der jeweils gleichen Fehlergruppe zugeordnet sind, den gleichen Signalfehler repräsentieren. Ein Fehler in dem Energieübertragungssystem in einem elektrischen Betriebsmittel kann zu einem Fehlersignal in dem erfassten Messsignal führen. Mehrere Fehlersignalfenster können deshalb mehrere Fehlersignale repräsentieren, die durch den gleichen Fehler bei der Energieübertragung mittels des elektrischen Betriebsmittels verursacht sind. Findet beispielsweise eine unerwünschte Teilentladung bei der elektrischen Energieübertragung mittels des elektrischen Betriebsmittels statt, können mehrere Fehlersignalfenster Teile des Messsignals repräsentieren, die von der Teilentladung stark beeinflusst sind. Dies führt oftmals dazu, dass die Fehlertupel, die basierend auf diesen Fehlersignalfenstern mittels der Prozessoreinheit ermittelt werden, durch den gleichen Fehlerursprung, nämlich die Teilentladung, geprägt sind. Es ist deshalb vorgesehen, dass diese Fehlertupel der gleichen Fehlergruppe zugeordnet werden. Es wurde festgestellt, dass derartige Fehlertupel nur einen geringen Abstand zueinander haben. Der maximale Abstand der Fehlertupel untereinander kann deshalb durch den zweiten, vorbestimmten Grenzwert bestimmt sein. Die Prozessoreinheit ist deshalb bevorzugt konfiguriert, die Fehlertupel in mehrere Fehlergruppen aufzuteilen, sodass die Fehlertupel der gleichen Fehlergruppe untereinander jeweils einen Abstand aufweisen, der kleiner als der zweite, vorbestimmte Grenzwert ist. Außerdem kann es vorgesehen sein, dass die Fehlertupel der gleichen Fehlergruppe zumindest im Wesentlichen in gleicher Distanz zu dem Rauschtupel angeordnet sind. Die Abweichung der Distanzen der Fehlertupel zu dem Rauschtupel ist vorzugsweise kleiner als der zweite, vorbestimmte Grenzwert. Dadurch kann gewährleistet werden, dass die Fehlertupel der gleichen Fehlergruppe den gleichen Signalfehler repräsentieren. Sie können also durch den gleichen Fehler bei der Energieübertragung mittels des elektrischen Betriebsmittels verursacht sein. Die Fehlergruppe kann auch als ein sogenanntes Cluster bezeichnet sein. Die Anzahl der unterschiedlichen Fehlergruppen gibt vorzugsweise die Anzahl der unterschiedlichen Fehler bei der Energieübertragung mittels des elektrischen Betriebsmittels an. Treten beispielsweise drei Teilentladungen bei der elektrischen Energieübertragung mittels des elektrischen Betriebsmittels auf, so können der erste und zweite vorbestimmte Grenzwert derart vorbestimmt und/oder gewählt sein, dass drei Fehlergruppen von der Prozessoreinheit erzeugt werden, wobei jede Fehlergruppe mehrere Fehlertupel aufweist, die jeweils den gleichen Teilentladungsfehler als Ursache haben.

Durch die Aufteilung der Fehlertupel in die Fehlergruppen kann besonders einfach und schnell erkannt werden, wie hoch die Anzahl der Fehler, insbesondere Teilentladungsfehler, bei der Energieübertragung ist. Außerdem kann anhand der Fehlertupel und der zugehörigen Fehlersignalfenster eine schnelle und präzise Analyse erfolgen, wo und mit welcher Intensität die Teilentladung stattgefunden hat.

Eine weitere vorteilhafte Ausgestaltung der Vorrichtung zeichnet sich dadurch aus, dass die Prozessoreinheit konfiguriert ist, die Fehlersignalfenster in mehrere Fehlergruppen aufzuteilen, so dass die Fehlertupel der Fehlersignalfenster der gleichen Fehlergruppe untereinander jeweils einen Abstand aufweisen, der kleiner als ein zweiter, vorbestimmter Grenzwert ist, so dass alle Fehlersignalfenster der jeweils gleichen Fehlergruppe den gleichen Signalfehler repräsentieren. Diese Ausgestaltung ist ähnlich zu der vorherigen Ausgestaltung der Vorrichtung. Anstatt der Gruppierung der Fehlertupel werden jedoch hier die Fehlersignalfenster gruppiert. Auf die vorherigen, bevorzugten Erläuterungen, vorteilhaften Merkmale, technischen Effekte und/oder Vorteile wird deshalb in analoger Weise für diese Ausgestaltung der Vorrichtung Bezug genommen.

Eine weitere vorteilhafte Ausgestaltung der Vorrichtung zeichnet sich dadurch aus, dass die Prozessoreinheit konfiguriert ist, eine Anzahl von unterschiedlichen Fehlern in dem Betriebsmittel basierend auf der Anzahl der Fehlergruppen zu ermitteln. Werden beispielsweise die Fehlertupel in drei Fehlergruppen oder die Fehlersignalfenster in drei Fehlergruppen mittels der Prozessoreinheit aufgeteilt, so kann die Prozessoreinheit basierend auf dieser Anzahl der Fehlergruppen auf die entsprechende Anzahl der unterschiedlichen Fehler schließen. Die Anzahl der Fehler entspricht nämlich vorzugsweise der Anzahl der Fehlergruppen.

Eine weitere vorteilhafte Ausgestaltung der Vorrichtung zeichnet sich dadurch aus, dass die Prozessoreinheit konfiguriert ist, ein Bildsignal zu erzeugen, das das Messsignal als Signalgraph repräsentiert, und wobei die Prozessoreinheit konfiguriert ist, die Teile des Signalgraphs optisch gleich zu indizieren, die auf Abtastwerten des Messsignals basieren, die Fehlersignalfenstern der gleichen Fehlergruppe zugeordnet sind. Auch wenn in diesem Zusammenhang auf die Fehlersignalfenster der gleichen Fehlergruppe Bezug genommen wird, kann analoges für die Fehlertupel der gleichen Fehlergruppe gelten, da jedes der Fehlertupel einem der Fehlersignalfenster zugeordnet ist. Die Teile des Signalgraphs können beispielsweise gleich indiziert sein, die von dem gleichen Fehler verursacht sind. Tritt beispielsweise ein Teilentladungsfehler bei der Energieübertragung mittels des elektrischen Betriebsmittels auf, können mehrere Fehlersignalfenster diesen Teilentladungsfehler durch entsprechende Signalkomponenten repräsentieren. Wie zuvor erläutert, können diese Fehlersignalfenster der gleichen Fehlergruppe zugeordnet sein. Es ist jedoch auch möglich, dass die zu den Fehlersignalfenstern zugeordneten Fehlertupel der gleichen Fehlergruppe zugeordnet sind. In beiden Fällen umfasst die Fehlergruppe Fehlersignalfenster bzw. durch Fehlertupel zugeordnete Fehlersignalfenster, die den Teilentladungsfehler oder einen anderen Fehler besonders prägnant optisch indizieren können. Die entsprechenden Teile des Signalgraphs, die durch die gleiche Gruppe der Fehlersignalfenster (oder zugehörige Tupel) bestimmt sind, werden mittels der Prozessoreinheit optisch gleich indiziert. Dies kann beispielsweise durch die gleiche Farbe (beispielsweise Rot, Grün oder Blau) erfolgen. Es ist jedoch auch möglich, dass die entsprechenden Teile des Signalgraphs durch die gleiche Strichelung, Linienstärke und/oder andere Merkmale gleich indiziert sind. Die Vorrichtung kann ausgebildet sein, um das Bildsignal zur Verfügung zu stellen. So kann die Vorrichtung beispielsweise eine Ausgangssignalschnittstelle aufweisen, wobei die Prozessoreinheit konfiguriert ist, die Ausgangssignalschnittstelle derart zu steuern, um das Bildsignal zu übertragen, insbesondere zu senden. Dadurch kann das Bildsignal an eine entfernte Einheit übertragen werden und gegebenenfalls dort dargestellt werden.

Eine weitere vorteilhafte Ausgestaltung der Vorrichtung zeichnet sich dadurch aus, dass die Vorrichtung eine Anzeigeeinheit aufweist. Außerdem kann die Prozessoreinheit konfiguriert sein, die Anzeigeeinheit derart zu steuern, sodass die Anzeigeeinheit ein Bild basierend auf dem Bildsignal darstellt, sodass das Bild den Signalgraph optisch wiedergibt. Der von dem Bild optisch wiedergegebene Signalgraph kann dabei Teile optisch gleich indizieren, die auf Abtastwerten des Messsignals basieren, die Fehlersignalfenstern der gleichen Fehlergruppe zugeordnet sind. Auf der Anzeigeeinheit lässt sich somit besonders schnell erkennen, welche Teile des Signalgraphs durch den gleichen Fehler, insbesondere den gleichen Teilentladungsfehler verursacht sind.

Eine weitere vorteilhafte Ausgestaltung der Vorrichtung zeichnet sich dadurch aus, dass die Prozessoreinheit konfiguriert ist, die Initialisierungsphase mehrfach auszuführen, sodass das Rauschtupel mit jeder Initialisierungsphase neu ermittelt wird. Dadurch kann eine Aktualisierung an eventuell sich änderndes Rauschen erreicht werden.

Eine weitere vorteilhafte Ausgestaltung der Vorrichtung zeichnet sich dadurch aus, dass die Prozessoreinheit konfiguriert ist, nach jeder Initialisierungsphase mindestens eine Untersuchungsphase auszuführen. Bevorzugt ist es vorgesehen, dass nach jeder Initialisierungsphase genau eine Untersuchungsphase mittels der Prozessoreinheit ausgeführt wird. Es kann jedoch auch vorgesehen sein, dass die Prozessoreinheit konfiguriert ist, nach jeder Initialisierungsphase mehrere Untersuchungsphasen auszuführen. In diesem Fall können die Untersuchungsphasen nacheinander von der Prozessoreinheit ausgeführt werden.

Gemäß einem zweiten Aspekt der Erfindung wird die eingangs genannte Aufgabe gelöst durch ein System mit den Merkmalen des Anspruchs 14. Vorgesehen ist also ein System zur Energieübertragung, wobei das System ein Betriebsmittel zur Übertragung eines elektrischen Energiesignals von einer Einspeisestelle des Betriebsmittels zu einer Bereitstellungsstelle des Betriebsmittels aufweist. Das System weist außerdem eine Sensoreinheit und eine Vorrichtung auf. Die Vorrichtung ist gemäß dem ersten Aspekt der Erfindung und/oder einer der zugehörigen, vorteilhaften Ausgestaltungen ausgebildet. Für die Vorrichtung des Systems wird auf die vorteilhaften Erläuterungen, bevorzugten Merkmale, technischen Effekte und/oder Vorteile, wie sie im Zusammenhang mit der Vorrichtung gemäß dem ersten Aspekt und/oder einer der zugehörigen, vorteilhaften Ausgestaltungen erläutert worden sind, in analoger Weise Bezug genommen. Die Sensoreinheit des Systems ist an einer Anschlussstelle des Betriebsmittels zwischen der Einspeisestelle und der Bereitstellungsstelle angeordnet. Die Sensoreinheit ist zur Erfassung des elektrischen Energiesignals und zur Erzeugung eines digitalen Messsignals ausgebildet, das das an der Anschlussstelle erfasste Energiesignal repräsentiert. Die Sensoreinheit ist mit der Signalschnittstelle der Vorrichtung gekoppelt, um das Messsignal an die Signalschnittstelle zu übertragen. Bezüglich der Vorteile des Systems und der technischen Effekte des Systems wird auf die technischen Effekte und Vorteile Bezug genommen, wie sie bereits im Zusammenhang mit der Vorrichtung gemäß dem ersten Aspekt der Erfindung und/oder einer der zugehörigen, vorteilhaften Ausgestaltungen erläutert worden sind. Auf Wiederholungen wird verzichtet.

Eine vorteilhafte Ausgestaltung des Systems zeichnet sich dadurch aus, dass das Betriebsmittel als eine Hochspannungsleitung, ein Transformator, eine rotierende elektrische Maschine, eine gasisolierte Leitung oder als eine gasisolierte Schaltanlage ausgebildet ist. Vorzugsweise weist das Betriebsmittel die Hochspannungsleitung auf, die sich von der Einspeisestelle des Betriebsmittels zu der Bereitstellungsstelle des Betriebsmittels erstreckt. Die Hochspannungsleitung kann zur Übertragung von elektrischer Energie mit einer hohen Gleichspannung oder einer hohen Wechselspannung ausgebildet sein. Alternativ und/oder ergänzend kann das Betriebsmittel einen Transformator aufweisen. Weist das Betriebsmittel den Transformator anstatt der Hochspannungsleitung auf, kann die Einspeisestelle an der Primärseite des Transformators und die Bereitstellungsstelle an der Sekundärseite des Transformators ausgebildet sein. Somit kann elektrische Energie von der Einspeisestelle, nämlich der Primärseite des Transformators zu der Bereitstellungsstelle, nämlich der Sekundärseite des Transformators, übertragen werden. Für die weiteren möglichen Ausgestaltungen des Betriebsmittels gelten die zuvor genannten technischen Effekte und/oder vorteilhaften Ausgestaltungen in analoger Weise.

Gemäß einem dritten Aspekt der Erfindung wird die eingangs genannte Aufgabe gelöst durch ein Verfahren mit den Merkmalen des Anspruchs 16. Vorgesehen ist also ein Verfahren zum Betrieb einer Vorrichtung mit einer Eingangsschnittstelle zum Empfang eines digitalen Messsignals mit einer Folge von Abtastwerten, wobei das Messsignal ein an eine Anschlussstelle eines elektrischen Betriebsmittels erfasstes Signal repräsentiert. Das Verfahren umfasst zumindest den folgenden Schritt: a) Mittels der Prozessoreinheit jedem Abtastwert des Messsignals jeweils ein Signalfenster zuordnen, das jeweils aus einem Teil der Folge von Abtastwerten des Messsignals mit dem jeweiligen Abtastwert und einer vorbestimmten Anzahl von zeitlich vorhergehenden Abtastwerten des Messsignals gebildet ist. Das Verfahren ist ausgebildet, in einer Initialisierungsphase mittels der Prozessoreinheit die folgenden Schritte auszuführen: b) eine Anzahl von M Signalfenstern als Initialisierungsfenster bestimmen, c) aus den M Initialisierungsfenstern eine Anzahl von K Initialisierungsfenstern als Rauschfenster bestimmen, d) jedes Rauschfenster mittels eines vorbestimmten Modells X'ter Ordnung analysieren und die zugehörigen Koeffizienten ermitteln, die ein dem jeweiligen Rauschfenster zugeordnetes Initialkoeffiziententupel bilden, wobei X eine gerade Zahl zwischen eins und fünf ist, und e) aus den Initialkoeffiziententupel der Rauschfenster einen Erwartungswert als Rauschtupel ermitteln. Darüber hinaus ist das Verfahren ausgebildet, in einer Untersuchungsphase mittels der Prozessoreinheit die folgenden Schritte auszuführen: f) eine Vielzahl der Signalfenster als Messfenster bestimmen, g) jedes Messfenster mittels des vorbestimmten Modells X'ter Ordnung analysieren und die zugehörigen Koeffizienten ermitteln, die ein dem jeweiligen Messfenster zugeordnetes Messtupel bilden, h) zu jedem Messfenster eine Distanz des zugehörigen Messtupels zu dem Rauschtupel ermitteln, und i) aus der Vielzahl der Messfenster die Messfenster als Fehlersignalfenster bestimmen, deren zugehöriges Messtupel jeweils eine Distanz zum Rauschtupel aufweisen, die größer als ein erster, vorbestimmter Grenzwert ist, so dass jedes Fehlersignalfenster einen Signalfehler des Messsignals repräsentiert.

Das Verfahren korrespondiert zumindest im Wesentlichen zu der Vorrichtung gemäß dem ersten Aspekt der Erfindung. Für das Verfahren wird deshalb auf die vorteilhaften Erläuterungen, bevorzugten Merkmale, Vorteile und/oder technischen Effekte zumindest in analoger Weise Bezug genommen, wie sie für die Vorrichtung gemäß dem ersten Aspekt der Erfindung und/oder den zugehörigen, vorteilhaften Ausgestaltungen erläutert worden sind. Auf eine Wiederholung wird verzichtet.

Eine vorteilhafte Ausgestaltung des Verfahrens zeichnet sich dadurch aus, dass die Initialisierungsphase mehrfach von der Prozessoreinheit ausgeführt wird, vorzugsweise 2 bis 10 Mal pro Sekunde. Durch die mehrfache Ausführung der Initialisierungsphase kann das Rauschtupel regelmäßig aktualisiert werden, um somit eine möglichst präzise Unterscheidung zwischen dem Rauschanteil des Messsignals und dem Fehleranteil des Messsignals zu erlauben. Vorzugsweise zeichnet sich das Verfahren auch dadurch aus, dass nach jeder Initialisierungsphase mindestens eine Untersuchungsphase mittels der Prozessoreinheit ausgeführt wird.

Eine weitere vorteilhafte Ausgestaltung des Verfahrens zeichnet sich dadurch aus, dass das Modell X'ter Ordnung durch ein LPC-Modell X'ter Ordnung ausgebildet ist. Auch in diesem Zusammenhang wird auf die entsprechenden, vorteilhaften Erläuterungen, bevorzugten Merkmale, Effekte und/oder Vorteile Bezug genommen, wie sie zu der entsprechenden, vorteilhaften Ausgestaltung der Vorrichtung gemäß dem ersten Aspekt der Erfindung bereits erläutert worden sind.

Eine weitere vorteilhafte Ausgestaltung des Verfahrens zeichnet sich dadurch aus, dass Schritt c) die folgenden Teilschritte c.1) und c.2) umfasst: c.1) zu jedem Initialisierungsfenster die zugehörige Anzahl der Nulldurchgänge des von dem jeweiligen Initialisierungsfenster repräsentierten Teils des Messsignals ermitteln, und c.2) aus den M Initialisierungsfenstern eine Anzahl von K Initialisierungsfenstern mit den meisten Nulldurchgängen als Rauschfenster bestimmen. Jedes der beiden Teilschritte c.1) und c.2) werden mittels der Prozessoreinheit ausgeführt. In Schritt c.1) erfolgt eine Ermittlung der Anzahl der Nulldurchgänge des von dem jeweiligen Initialisierungsfenster repräsentierten Teil des Messsignals mittels der Prozessoreinheit. Und in Schritt c.2) erfolgt die Bestimmung der Anzahl von K Rauschfenstern aus den M Initialisierungsfenstern anhand der Anzahl der Nulldurchgänge mittels der Prozessoreinheit. Auch für diese Ausgestaltung des Verfahrens wird auf die vorteilhaften Erläuterungen, bevorzugten Merkmale, technischen Effekte und Vorteile in analoger Weise Bezug genommen, wie sie für die entsprechend vorteilhafte Ausgestaltung der Vorrichtung gemäß dem ersten Aspekt der Erfindung bereits zuvor erläutert worden sind. Auf eine Wiederholung wird auch hier verzichtet.

Eine weitere vorteilhafte Ausgestaltung des Verfahrens zeichnet sich dadurch aus, dass Schritt c) die folgenden Teilschritte c.1) und c.2) umfasst: c.1) zu jedem Initialisierungsfenster die zugehörige Signalenergie des von dem jeweiligen Initialisierungsfenster repräsentierten Teils des Messsignals ermitteln, und c.2) aus den M Initialisierungsfenstern eine Anzahl von K Initialisierungsfenstern mit den kleinsten Signalenergien als Rauschfenster bestimmen. Jedes der beiden Teilschritte c.1) und c.2) werden mittels der Prozessoreinheit ausgeführt. In Schritt c.1) erfolgt eine Ermittlung der Signalenergie des von dem jeweiligen Initialisierungsfenster repräsentierten Teil des Messsignals mittels der Prozessoreinheit. Und in Schritt c.2) erfolgt die Bestimmung der Anzahl von K Rauschfenstern aus den M Initialisierungsfenstern anhand der kleinsten Signalenergie mittels der Prozessoreinheit. Auch für diese Ausgestaltung des Verfahrens wird auf die vorteilhaften Erläuterungen, bevorzugten Merkmale, technischen Effekte und Vorteile in analoger Weise Bezug genommen, wie sie für die entsprechend vorteilhafte Ausgestaltung der Vorrichtung gemäß dem ersten Aspekt der Erfindung bereits zuvor erläutert worden sind. Auf eine Wiederholung wird auch hier verzichtet.

Eine weitere vorteilhafte Ausgestaltung des Verfahrens zeichnet sich dadurch aus, dass das Verfahren ausgebildet ist, in der Untersuchungsphase mittels der Prozessoreinheit außerdem den folgenden Schritt auszuführen: j) jedes Fehlersignalfenster mittels eines vorbestimmten Modells N-ter Ordnung analysieren und die zugehörigen Koeffizienten ermitteln, die ein dem jeweiligen Fehlersignalfenster zugeordnetes Fehlertupel bilden, wobei N eine ganze Zahl von mindestens sechs, vorzugsweise acht ist.

Eine weitere vorteilhafte Ausgestaltung des Verfahrens zeichnet sich dadurch aus, dass das Verfahren ausgebildet ist, in der Untersuchungsphase mittels der Prozessoreinheit außerdem den folgenden Schritt auszuführen: k) die Fehlertupel in mehrere Fehlergruppen aufteilen, so dass die Fehlertupel der gleichen Fehlergruppe untereinander jeweils einen Abstand aufweisen, der kleiner als ein zweiter, vorbestimmter Grenzwert ist, so dass alle Fehlersignalfenster, die durch ihre zugehörigen Fehlertupel der jeweils gleichen Fehlergruppe zugeordnet sind, den gleichen Signalfehler repräsentieren.

Für die beiden zuletzt genannten, vorteilhaften Ausgestaltungen des Verfahrens wird jeweils auf die vorteilhaften Erläuterungen, bevorzugten Merkmale, Effekte und/oder Vorteile in analoger Weise Bezug genommen, wie sie für die beiden entsprechenden, vorteilhaften Ausgestaltungen der Vorrichtung gemäß dem ersten Aspekt der Erfindung bereits zuvor erläutert worden sind.

Weitere Merkmale, Vorteile und Anwendungsmöglichkeiten der vorliegenden Erfindung ergeben sich aus der nachfolgenden Beschreibung der Ausführungsbeispiele und den Figuren. Dabei bilden alle beschriebenen und/oder bildlich dargestellten Merkmale für sich und in beliebiger Kombination den Gegenstand der Erfindung auch unabhängig von ihrer Zusammensetzung in den einzelnen Ansprüchen oder deren Rückbezügen. In den Figuren stehen weiterhin gleiche Bezugszeichen für gleiche oder ähnliche Objekte.

Figur 1     zeigt eine vorteilhafte Ausgestaltung der Vorrichtung und des Systems in einer schematischen Darstellung.
Figur 2     zeigt eine beispielhafte Verteilung einer Vielzahl von Koeffiziententupel.
Figur 3     zeigt einen beispielhaften Ausschnitt eines Messsignals.
Figur 4     zeigt eine beispielhafte Ausgestaltung des Verfahrens in einem schematischen Ablaufplan.
Figur 5     zeigt eine weitere, vorteilhafte Ausgestaltung des Verfahrens in einem schematischen Ablaufplan.

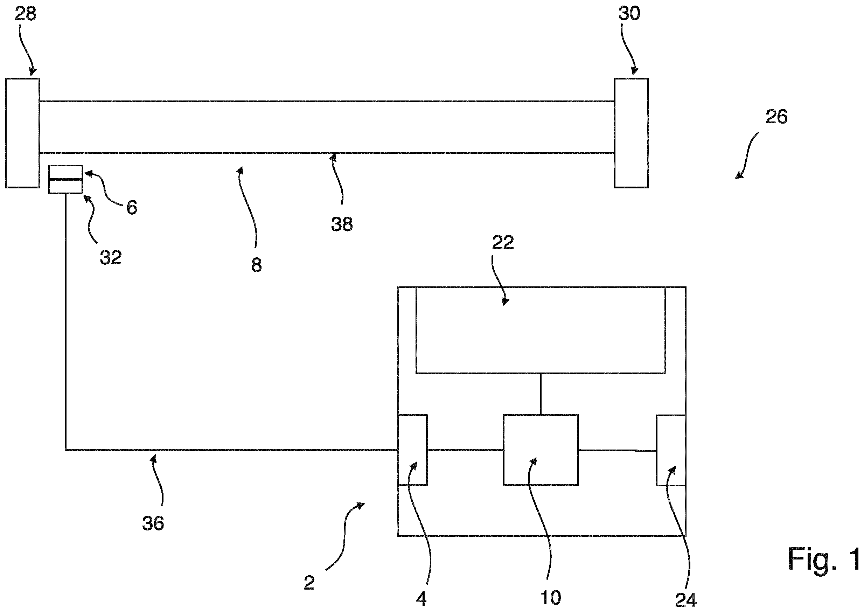

In der Figur 1 ist eine vorteilhafte Ausgestaltung der Vorrichtung 2 schematisch dargestellt. Die Vorrichtung 2 weist einen Eingangssignalschnittstelle 4 und eine Prozessoreinheit 10 auf. Außerdem kann die Vorrichtung 2 eine Anzeigeeinheit 22 aufweisen. Bevorzugt ist es vorgesehen, dass die Vorrichtung 2 eine Ausgangssignalschnittstelle 24 aufweist.

In der Figur 1 ist außerdem ein elektrisches Betriebsmittel 8 schematisch dargestellt. Das elektrische Betriebsmittel 8 dient zur Übertragung von elektrischer Energie. So kann das elektrische Betriebsmittel 8 beispielsweise zur Hochspannungs-Gleichstrom-Übertragung ausgebildet sein. Es ist jedoch auch möglich, dass das elektrische Betriebsmittel 8 in einer anderen Weise zur Übertragung von elektrischer Energie ausgebildet ist. So kann das elektrische Betriebsmittel 8 beispielsweise zur Hochspannungs-Wechselstrom-Übertragung ausgebildet sein. Das elektrische Betriebsmittel 8 weist vorzugsweise eine Einspeiseschnittstelle 28 und eine Bereitstellungsschnittstelle 30 auf. Von der Einspeiseschnittstelle 28 kann sich mindestens eine elektrische Leitung 38 zu der Bereitstellungsschnittstelle 30 erstrecken. Über die elektrische Leitung 38 kann ein Stromfluss erzeugt werden. Die in Figur 1 dargestellte, vorteilhafte Ausgestaltung des elektrischen Betriebsmittels 8 ist jedoch nur beispielhaft zu verstehen. So kann das elektrische Betriebsmittel 8 in einer alternativen Ausgestaltung von einem Transformator gebildet sein, dessen primärseitiger Anschluss die Einspeiseschnittstelle 28 und dessen sekundärseitiger Anschluss die Bereitstellungsschnittstelle 30 bilden.

Das elektrische Betriebsmittel 8 und die Vorrichtung 2 können einen Teil eines Systems 26 bilden. Für das System 26 kann es außerdem vorgesehen sein, dass das System 26 eine Sensoreinheit 32 aufweist, die vorzugsweise über eine Signalleitung 36 mit der Eingangssignalschnittstelle 4 der Vorrichtung 2 gekoppelt ist. Die Sensoreinheit 32 kann an eine Anschlussstelle 6 des elektrischen Betriebsmittels 8 angeordnet sein, um die Energieübertragung elektrisch zu erfassen. So kann die Sensoreinheit 32 beispielsweise zur Erfassung einer elektrischen Spannung und/oder zur Erfassung eines elektrischen Stroms durch die elektrische Leitung 38 ausgebildet sein. Die Sensoreinheit 32 ist somit zur Erfassung eines elektrischen Energiesignals des elektrischen Betriebsmittels 8 ausgebildet. Die Sensoreinheit 32 ist außerdem zur Erzeugung eines analogen Messsignals ausgebildet, das das an der Anschlussstelle 6 erfasste Energiesignal repräsentiert. Das Messsignal kann mittels der Signalleitung 36 von der Sensoreinheit 32 an die Eingangssignalschnittstelle 4 der Vorrichtung 2 übertragen werden. Dort wird es von der Prozessoreinheit 10 digitalisiert. Das digitale Messsignal ist eine Folge von Abtastwerten des erfassten Signals. Die Eingangssignalschnittstelle 4 der Vorrichtung 2 ist zum Empfang des digitalen Messsignals mit der zugehörigen Folge von Abtastwerten ausgebildet.

Die vorherigen und folgenden Erläuterungen der Vorrichtung 2 können sich vorzugsweise allein auf die Vorrichtung 2 beziehen. Es ist jedoch auch vorgesehen, dass die gleichen Erläuterungen zu der Vorrichtung 2 in analoger Weise für das System 26 gelten, da das System 26 die Vorrichtung 2 umfassen kann. Umgekehrt kann entsprechendes gelten.

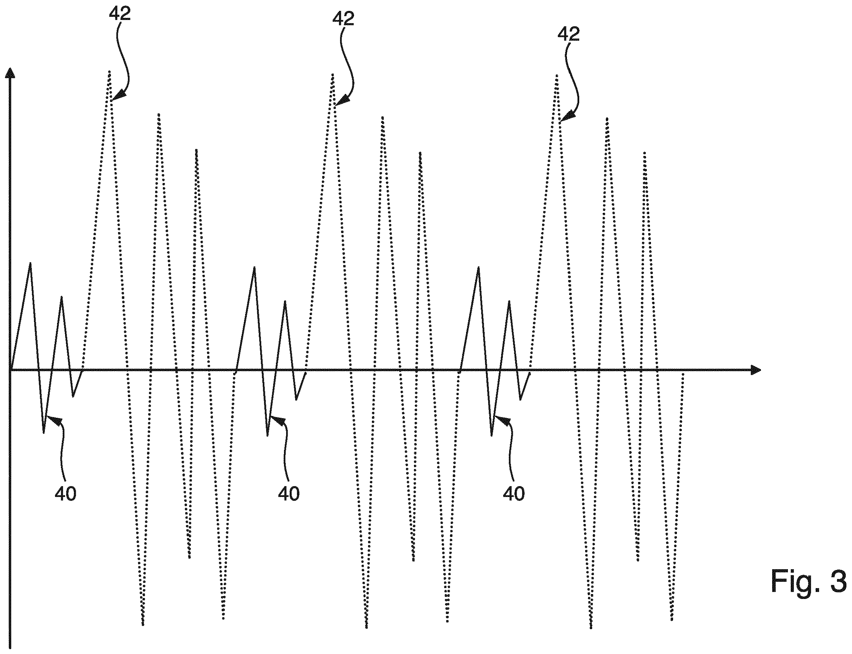

In der Figur 3 ist ein beispielhafter Ausschnitt eines Messsignals über die Zeit aufgetragen und schematisch dargestellt. Grundsätzlich repräsentiert zumindest ein Teil des Messsignals das an der Anschlussstelle 6 des elektrischen Betriebsmittels 8 erfasste Energiesignal. Kommt es jedoch zu einem Fehler, beispielsweise einer Teilentladung in der elektrischen Leitung 38, verursacht dieser Fehler, insbesondere die Teilentladung, eine zugehörige Signalkomponente in dem Messsignal. Dabei besteht die Schwierigkeit festzustellen, welche Teile des Messsignals eine Signalkomponente umfassen, die den jeweiligen Fehler besonders prägnant repräsentieren.

Die Vorrichtung 2 dient deshalb zumindest auch dem Zweck zur Ermittlung von Fehlersignalfenstern des Messsignals, wobei jedes Fehlersignalfenster einen Signalfehler des Messsignals repräsentiert. Die Fehlersignalfenster können dabei unterschiedliche Signalfehler repräsentieren. Es ist jedoch auch möglich, dass zumindest mehrere Fehlersignalfenster den gleichen Signalfehler des Messsignals repräsentieren. Dies ist insbesondere dann der Fall, wenn diese Signalfehler durch den gleichen Fehler, wie eine Teilentladung, verursacht sind. Jedes Fehlersignal kann somit ein Teil der Komponente des Messsignals sein, der durch einen Fehler, insbesondere eine Teilentladung, in dem elektrischen Betriebsmittel 8 bei der Energieübertragung auftritt.

Um den gewünschten Zweck der Vorrichtung 2 zu gewährleisten, ist eine vorteilhafte Konfiguration der Prozessoreinheit 10 vorgesehen, die im Folgenden erläutert werden soll.

Die Prozessoreinheit 10 ist konfiguriert, jedem Abtastwert des Messsignals jeweils ein Signalfenster zuzuordnen, das jeweils aus einem Teil der Folge von Abtastwerten des Messsignals mit dem jeweiligen Abtastwert und einer vorbestimmten Anzahl von zeitlich vorhergehenden Abtastwerten des Messsignals gebildet ist. Jedes Signalfenster kann die gleiche Anzahl von Abtastwerten des Messsignals umfassen. So kann es beispielsweise vorgesehen sein, dass jedes Signalfenster 32, 64 oder 128 Abtastwerte des Messsignals umfasst. Die Abtastwerte eines Signalfensters sind ein Teil der Folge der Abtastwerte des Messsignals. Die Abtastwerte des jeweiligen Signalfensters sind deshalb zeitlich direkt hintereinander folgende Abtastwerte. Wird von der Prozessoreinheit 10 beispielsweise für einen Abtastwert des Messsignals ein Signalfenster erzeugt und dem jeweiligen Abtastwert zugeordnet, so umfasst dieses Signalfenster den jeweiligen Abtastwert des Messsignals und eine vorbestimmte Anzahl von zeitlich vorhergehenden Abtastwerten, beispielsweise 127 zeitlich vorhergehende Abtastwerte zu dem jeweiligen Abtastwert des Messsignals. Insgesamt umfasst das Signalfenster in diesem Beispiel 128 Abtastwerte. Da jedem Abtastwert des Messsignals ein Signalfenster zugeordnet ist, wird auch davon gesprochen, dass die entsprechend erzeugten Signalfenster eine sich bewegende Folge von Signalfenstern ist. Wenn im Folgenden die Initialisierungsphase 12 und Untersuchungsphase 18 erläutert werden, ist zu berücksichtigen, dass die Zuordnung der Signalfenster zu jedem Abtastwert des Messsignals weiterhin, und insbesondere zeitlich parallel erfolgt.

Die Prozessoreinheit 10 ist konfiguriert, in einer Initialisierungsphase 12 mehrere Schritte auszuführen, die im Folgenden erläutert werden sollen. So ist die Prozessoreinheit 10 konfiguriert, während der Initialisierungsphase 12 eine Anzahl von M Signalfenstern als Initialisierungsfenster zu bestimmen. Hierbei handelt es sich um einen Teil der Signalfenster, die den Abtastwerten des Messsignals mittels der Prozessoreinheit 10 fortlaufend zugeordnet werden. Die Anzahl M ist eine ganze Zahl zwischen 100 und 50.000. Vorzugsweise ist die Anzahl M eine ganze Zahl zwischen 1.000 und 10.000. Somit können in der Initialisierungsphase 12 beispielsweise 10.000 Initialisierungsfenster mittels der Prozessoreinheit 10 bestimmt werden. Aus diesen Initialisierungsfenstern wird eine Anzahl von K Rauschfenstern bestimmt. Die Anzahl K ist kleiner als die Anzahl M. So kann die Anzahl K eine ganze Zahl sein und vorzugsweise kleiner als das 0,5-fache oder das 0,1-fache der Anzahl M sein. Beispielhaft wird angenommen, dass die Zahl K 1.000 ist. Somit können mittels der Prozessoreinheit 10 beispielsweise 1.000 Rauschfenster aus der Menge der Initialisierungsfenster bestimmt werden. Welche der Initialisierungsfenster als Rauschfenster bestimmt werden, kann durch eine Ermittlung der Anzahl der Nulldurchgänge oder durch eine Ermittlung der Signalenergie der von den Initialisierungsfenstern repräsentierten Teilen des Messsignals festgestellt werden. Die Prozessoreinheit kann hierzu konfiguriert sein, um zu jedem Initialisierungsfenster die zugehörige Anzahl der Nulldurchgänge oder die zugehörige Signalenergie des von dem jeweiligen Initialisierungsfenster repräsentierten Teil des Messsignals zu ermitteln. Jedem Initialisierungsfenster ist somit eine Anzahl von Nulldurchgängen oder eine bestimmte Signalenergie zugeordnet. Die Anzahl der Nulldurchgänge oder die bestimmte Signalenergie der Initialisierungsfenster unterscheidet sich für gewöhnlich. Diejenigen Initialisierungsfenster, denen jeweils die größte Anzahl von Nulldurchgängen oder die kleinste Signalenergie zugeordnet ist, repräsentieren die Teile des Messsignals mit dem größten Anteil an Rauschen. Die Prozessoreinheit 10 ist deshalb konfiguriert, aus den M Initialisierungsfenstern diejenigen Initialisierungsfenster mit den meisten Nulldurchgängen oder mit der kleinsten Signalenergie als die Rauschfenster zu bestimmen. Die Rauschfenster bilden somit eine Untermenge aller Initialisierungsfenstern, wobei die von den Rauschfenstern repräsentierten Teile des Messsignals von einem großen Rauschanteil geprägt sind.

Von der Prozessoreinheit 10, und insbesondere einer zugehörigen Speichereinheit, kann ein Modell X'ter Ordnung gespeichert sein. Bei dem Modell handelt es sich vorzugsweise um ein mathematisches Modell, das zur Modellierung der Energieübertragung mittels des Betriebsmittels 8 ausgebildet ist. Das Modell kann Koeffizienten aufweisen, um eine von dem Modell repräsentierte Übertragungsfunktion bzw. einen Übertragungsweg anzupassen. Durch die Anpassung der Koeffizienten des Modells kann somit erreicht werden, dass in Abhängigkeit der gewählten Koeffizienten eine besonders gute Approximation der tatsächlichen Übertragungsfunktion bei der Energieübertragung mittels des Betriebsmittels 8 erreicht wird. Das Modell wird auch als das vorbestimmte Modell bezeichnet. Die Prozessoreinheit 10 ist konfiguriert, in der Initialisierungsphase 12 jedes Rauschfenster mittels des vorbestimmten Modells X'ter Ordnung zu analysieren und dadurch die zugehörigen Koeffizienten zu ermitteln. Somit wird für jedes Rauschfenster ein zugehöriger Satz von Koeffizienten ermittelt. Die Koeffizienten können sich von Rauschfenster zu Rauschfenster unterscheiden. Um eine schnelle Ermittlung zu erreichen, hat es sich als vorteilhaft herausgestellt, wenn X eine gerade Zahl zwischen eins und fünf ist. So kann X beispielsweise die Zahl zwei sein. In diesem Fall wäre das vorbestimmte Modell ein Modell zweiter Ordnung. Die Anzahl der Koeffizienten entspricht vorzugsweise der Ordnung des Modells. In dem vorherigen Beispiel wären somit zwei Koeffizienten für das Modell zweiter Ordnung vorgesehen. Die für ein Rauschfenster mittels der Prozessoreinheit 10 ermittelten Koeffizienten bilden jeweils ein dem jeweiligen Rauschfenster zugeordnetes Initialkoeffiziententupel 14. Das Rauschen kann sich von Rauschfenster zu Rauschfenster unterscheiden, sodass auch die Initialkoeffiziententupel 14 von Rauschfenster zu Rauschfenster unterschiedlich sein können. Die Prozessoreinheit 10 ist deshalb konfiguriert, in der Initialisierungsphase 12 aus dem Initialkoeffiziententupel 14 der Rauschfenster einen Erwartungswert als Rauschtupel 16 zu ermitteln. Das Rauschtupel 16 kann somit der arithmetische Mittelwert der K Initialkoeffiziententupel 14 sein. Besteht jedes Initialkoeffiziententupel 14 aus zwei Koeffizienten und werden beispielsweise 1.000 Rauschfenster und somit 1.000 Initialkoeffiziententupel 14 ermittelt, so kann das Rauschtupel 16 einen Erwartungswert für die Initialkoeffiziententupel 14 repräsentieren. Das Rauschtupel 16 kann vereinfacht gesprochen im "Rauschzentrum" angeordnet sein. Wird nun ein anders Signalfenster als Initialisierungsfenster mittels des vorbestimmten Modells analysiert und die zugehörigen Koeffizienten ermittelt, so kann basierend auf der Distanz zwischen dem Rauschtupel 16 und dem entsprechenden Tupel aus den Koeffizienten ermittelt werden, ob das entsprechende Signalfenster als Rauschen zu bewerten ist oder, wenn der Abstand groß genug ist, das Signalfenster einen Teil des Messsignals mit einem Signalfehler repräsentiert.

Die Prozessoreinheit 10 ist konfiguriert in der Untersuchungsphase 18 mehrere Schritte auszuführen, die im Folgenden erläutert werden. So ist die Prozessoreinheit 10 konfiguriert, in der Untersuchungsphase 18 eine Vielzahl von Signalfenstern als Messfenster zu bestimmen. Dabei ist es bevorzugt vorgesehen, dass sich die Messfenster von den Initialisierungsfenstern unterscheiden. So können beispielsweise diejenigen Signalfenster als Messfenster bestimmt werden, die an das letzte Initialisierungsfenster anschließen. Die Anzahl der Messfenster ist vorzugsweise deutlich größer als die Anzahl der Initialisierungsfenster. So können in der Untersuchungsphase 18 beispielsweise mindestens 10.000 Signalfenster zu Messfenstern bestimmt werden. Bevorzugt sind es jedoch deutlich mehr, beispielsweise 20.000, 30.000 oder 100.000. Die Prozessoreinheit 10 ist außerdem konfiguriert, jedes Messfenster mittels des vorbestimmten Modells X'ter Ordnung zu analysieren und dadurch die zugehörigen Koeffizienten zu ermitteln. Hierbei handelt es sich um das gleiche Modell X'ter Ordnung, das auch schon in der Initialisierungsphase 12 verwendet wurde. Zu jedem Messfenster werden also zugehörige Koeffizienten ermittelt, die ein dem jeweiligen Messfenster zugeordnetes Messtupel 20 bilden. Für jedes Messfenster ist also ein Messtupel 20 aus den jeweiligen Koeffizienten vorgesehen.

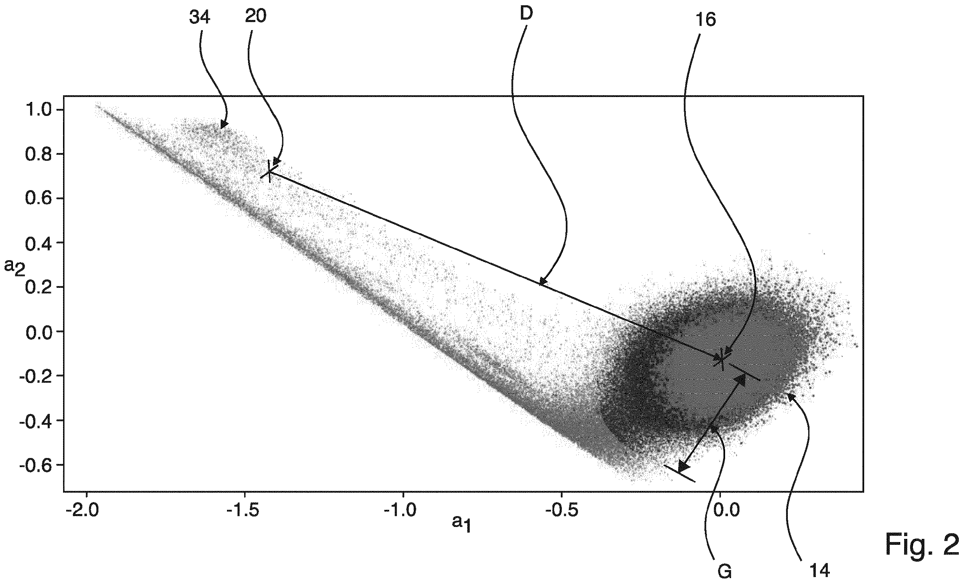

In der Figur 2 ist eine Vielzahl von Koeffiziententupel 34 durch entsprechende Punkte schematisch dargestellt. Jedes Koeffiziententupel 34 besteht aus Koeffizienten, die bei der Analyse eines Signalfensters mittels des Modells X'ter Ordnung ermittelt worden sind. Diese Analyse findet in Bezug auf die Rauschfenster in der Initialisierungsphase 12 statt. Dadurch entsteht eine Vielzahl von Initialkoeffiziententupel 14, die in der Figur 2 aufgrund ihrer Vielzahl als eine Wolke aus Punkten wiedergegeben sind. Im Zentrum dieser Wolke aus Initialkoeffiziententupel 14 ist das Rauschtupel 16 angeordnet. Das Rauschtupel 16 bildet somit den Erwartungswert für die Initialkoeffiziententupel 14.

In der Untersuchungsphase 18 werden die Messfenster mit dem gleichen Modell X'ter Ordnung analysiert, sodass zugehörige Koeffizienten die zuvor genannten Messtupel 20 bilden. Einer dieser Messtupel 20 ist in Figur 2 durch ein Kreuz markiert. Um festzulegen, ob ein Messtupel 20 ein Rauschen des von dem zugehörigen Messfenster repräsentierten Teil des Messsignals angibt, oder ob das Messtupel 20 für das jeweilige Messfenster auf einen Signalfehler in dem von dem Messfenster repräsentierten Teil des Messsignals hindeutet, ist ein vorbestimmter, erster Grenzwert G festgelegt. Ist die Distanz D zwischen dem jeweiligen Messtupel 20 und dem Rauschtupel 16 größer als der erste Grenzwert G, so wird der von dem zugehörigen Messfenster repräsentierte Teil des Messsignals als ein Signalfehler angesehen, der durch einen Fehler bei der Energieübertragung mittels des Betriebsmittels 8 aufgetreten ist. Wäre die Distanz D jedoch kleiner als der Grenzwert G, würde dieses Messtupel 20 darauf hindeuten, dass der von dem zugehörigen Messfenster repräsentierte Teil des Messsignals keinen Signalfehler repräsentiert, sondern von Rauschen geprägt ist.

Die Prozessoreinheit 10 ist deshalb konfiguriert, in der Untersuchungsphase 18 zu jedem Messfenster die Distanz D des zugehörigen Messtupels 20 zu dem Rauschtupel 16 zu ermitteln, und aus der Vielzahl der Messfenster diejenigen Messfenster als Fehlersignalfenster zu bestimmen, deren zugehöriges Messtupel 20 jeweils eine Distanz D zum Rauschtupel 16 aufweist, die größer als der erste, vorbestimmte Grenzwert G ist. Dadurch wird erreicht, dass jedes der auf dieser Weise bestimmten Fehlersignalfenster einen Teil des Messsignals repräsentiert, das einen Signalfehler umfasst. Denn jedes dieser von den Fehlersignalfenstern repräsentierten Teile des Messsignals ist zumindest teilweise durch einen Fehler bei der Energieübertragung mittels des Betriebsmittels 8 geprägt. Der Signalfehler eines Messsignals ist beispielsweise der von dem jeweiligen Fehler verursachte Anteil des Messsignals. Jedes Fehlersignalfenster repräsentiert deshalb auch einen Signalfehler des Messsignals.

Die in der Untersuchungsphase 18 festgestellten Fehlersignalfenster repräsentieren die jeweils relevanten Teile des Messsignals, die zur Untersuchung möglicher Fehler bei der Energieübertragung mittels des elektrischen Betriebsmittels 8 verwendet werden können.

Bevorzugt ist es deshalb vorgesehen, dass die Vorrichtung 2 eine Ausgangssignalschnittstelle 24 aufweist, die zum Übertragen eines Ausgangssignals ausgebildet ist. Das Ausgangssignal kann die Fehlersignalfenster direkt oder indirekt repräsentieren. So kann das Ausgangssignal beispielsweise Daten zur Identifizierung der Fehlersignalfenster in dem Messsignal umfassen. Es kann jedoch auch vorgesehen sein, dass das Ausgangssignal jedes der Signalfenster repräsentiert. Die Prozessoreinheit 10 der Vorrichtung 2 kann dazu ausgebildet sein, die Ausgangssignalschnittstelle 24 derart zu steuern, um das Ausgangssignal zu übertragen, insbesondere zu versenden. Über das Ausgangssignal können die von der Vorrichtung 2 ermittelten Informationen zu den Fehlersignalfenstern für weitere Vorrichtungen und/oder Einheiten zur Verfügung gestellt werden.

Alternativ oder ergänzend zu der Ausgangssignalschnittstelle 24 kann die Vorrichtung 2 eine Anzeigeeinheit 22 aufweisen. Außerdem kann die Prozessoreinheit 10 dazu konfiguriert sein, ein Bildsignal zu erzeugen, das das Messsignal als Signalgraph repräsentiert. Die Prozessoreinheit 10 kann derart konfiguriert sein, das Bildsignal an die Anzeigeeinheit 22 zu übertragen. Die Anzeigeeinheit 22 kann zur Erzeugung eines Bilds auf der Anzeigeeinheit 22 basierend auf dem Bildsignal ausgebildet sein.

Weiterhin ist es vorteilhaft vorgesehen, dass die Prozessoreinheit 10 konfiguriert ist, die Teile des vom Bildsignal repräsentierten Signalgraphs optisch gleich zu indizieren, die auf Abtastwerten des Messsignals basieren, die Fehlersignalfenstern der gleichen Fehlergruppe zugeordnet sind. Dabei kann die Prozessoreinheit 10 konfiguriert sein, Fehlersignalfenster in mehrere Fehlergruppen aufzuteilen. Fehlersignalfenster der gleichen Fehlergruppe können jeweils ein Fehlersignal repräsentieren, das durch den gleichen Fehler bei der Energieübertragung mittels des elektrischen Betriebsmittels 8 verursacht ist.

In der Figur 3 ist ein Ausschnitt des Messsignals dargestellt, wobei die Signalfenster 40 einer ersten Fehlergruppe als durchgezogene Linie und die Signalfenster 42 einer zweiten Fehlergruppe als gepunktete Linie dargestellt sind. Vorzugsweise ist die Prozessoreinheit 10 konfiguriert, die Anzeigeeinheit 22 derart zu steuern, sodass die Anzeigeeinheit 22 ein entsprechendes Bild basierend auf dem Bildsignal darstellt, sodass das Bild den Signalgraph und vorzugsweise die Teile des Signalgraphs mit der jeweiligen gleichen Indizierung optisch wiedergibt.

Für die Initialisierungsphase 12 und die Untersuchungsphase 18 wurde bereits erläutert, dass jeweils ein Modell X'ter Ordnung zur Analyse verwendet wird. Bei dem Modell X'ter Ordnung handelt es sich vorzugsweise um ein LPC-Modell X'ter Ordnung. Alternativ kann auch ein anderes mathematisches Modell verwendet werden. Dies kann beispielsweise unter Zuhilfenahme einer Fourier-Transformation oder einer Wavelet-Transformation gebildet sein.

Außerdem hat es sich als vorteilhaft herausgestellt, wenn jedes der Fehlersignalfenster mittels eines Modells höherer Ordnung analysiert wird. Dabei kann dieses Modell höherer Ordnung von dem gleichen Typ sein wie das Modell X'ter Ordnung. Bevorzugt ist es deshalb vorgesehen, dass die Prozessoreinheit 10 konfiguriert ist, jedes Fehlersignalfenster mittels eines vorbestimmten Modells N-ter Ordnung zu analysieren und dadurch die zugehörigen Koeffizienten zu ermitteln, die ein dem jeweiligen Fehlersignalfenster zugeordnetes Fehlertupel bilden, wobei N eine ganze Zahl von mindestens sechs und vorzugsweise mindestens acht ist. Das Modell N-ter Ordnung kann ebenfalls von der Prozessoreinheit 10, und insbesondere einer zugehörigen Speichereinheit, gespeichert sein. Außerdem ist es bevorzugt vorgesehen, dass das Modell N-ter Ordnung ein LPC-Modell N-ter Ordnung ist. Die N-te Ordnung kann, wie zuvor erläutert, mindestens sechs, mindestens acht, aber auch vorzugsweise mindestens zehn, zwölf oder vierzehn sein. Die höhere Ordnung des Modells N-ter Ordnung bietet den Vorteil, dass die Fehlersignalfenster genauer analysiert werden können, um den jeweiligen Fehler genauer untersuchen zu können. Außerdem können die Fehlersignalfenster basierend auf den Fehlertupeln gruppiert werden. So ist es beispielsweise vorteilhaft vorgesehen, dass die Prozessoreinheit 10 konfiguriert ist, die Fehlertupel in mehrere Fehlergruppen aufzuteilen, sodass die Fehlertupel der gleichen Fehlergruppe untereinander jeweils einen Abstand aufweisen, der kleiner als ein zweiter, vorbestimmter Grenzwert G ist. Alle Fehlersignalfenster, die durch ihre zugehörigen Fehlertupel der jeweils gleichen Fehlergruppe zugeordnet sind, können deshalb den gleichen oder einen zumindest ähnlichen Signalfehler repräsentieren. Jeder dieser Signalfehler kann durch den gleichen Fehler bei der Energieübertragung mittels des elektrischen Betriebsmittels 8 verursacht sein. Fehlertupel und/oder Fehlersignalfenster, die den gleichen Fehlerursprung, insbesondere verursacht durch die gleiche Teilentladung, haben, können so der gleichen Fehlergruppe zugeordnet werden. Die Anzahl der Gruppen kann deshalb der Anzahl der unterschiedlichen Fehler bei der Energieübertragung mittels des elektrischen Betriebsmittels 8 entsprechen.

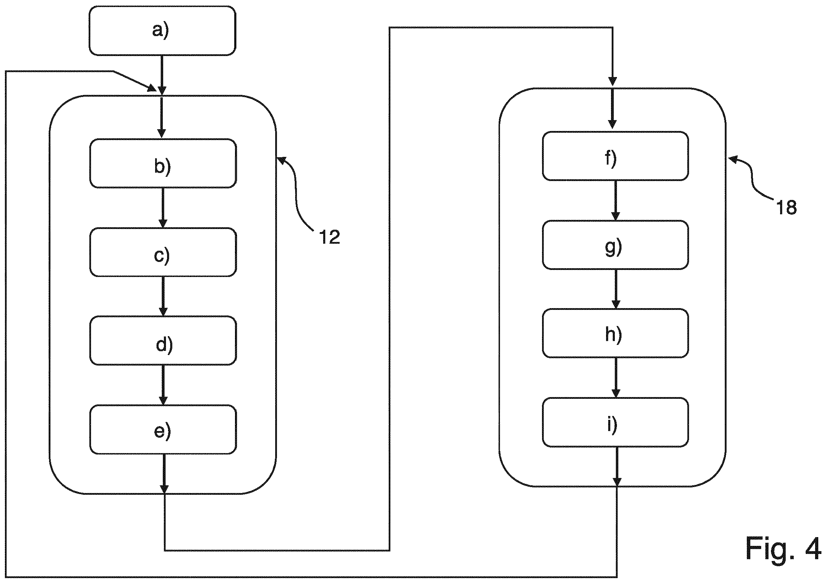

In der Figur 4 ist eine vorteilhafte Ausgestaltung des Verfahrens dargestellt. Das Verfahren umfasst die Verfahrensschritte a) bis i). Gemäß Verfahrensschritt a) wird mittels der Prozessoreinheit 10 jedem Abtastwert des Messsignals jeweils ein Signalfenster zugeordnet, das jeweils aus einem Teil der Folge von Abtastwerten des Messsignals mit dem jeweiligen Abtastwert und einer vorbestimmten Anzahl von zeitlich vorhergehenden Abtastwerten des Messsignals gebildet ist. Der Schritt a) wird kontinuierlich, und zwar auch vorzugsweise zeitparallel zu der Initialisierungsphase 12 und/oder der Untersuchungsphase 18 ausgeführt.

Die Verfahrensschritte b) bis e) sind der Initialisierungsphase 12 zugeordnet. Das Verfahren ist ausgebildet, in der Initialisierungsphase 12 mittels der Prozessoreinheit 10 die folgenden Schritte auszuführen: b) eine Anzahl von M Signalfenstern als Initialisierungsfenster bestimmen, c) aus den M Initialisierungsfenstern eine Anzahl von K Initialisierungsfenstern als Rauschfenster bestimmen, d) jedes Rauschfenster mittels eines vorbestimmten Modells X'ter Ordnung analysieren und die zugehörigen Koeffizienten ermitteln, die ein dem jeweiligen Rauschfenster zugeordnetes Initialkoeffiziententupel bilden, wobei X eine gerade Zahl zwischen eins und fünf ist, und e) aus den Initialkoeffiziententupel der Rauschfenster einen Erwartungswert als Rauschtupel ermitteln.

Außerdem ist das Verfahren ausgebildet, in der Untersuchungsphase 18 mittels der Prozessoreinheit 10 die folgenden Schritte auszuführen: f) eine Vielzahl der Signalfenster als Messfenster bestimmen, g) jedes Messfenster mittels des vorbestimmten Modells X'ter Ordnung analysieren und die zugehörigen Koeffizienten ermitteln, die ein dem jeweiligen Messfenster zugeordnetes Messtupel bilden, h) zu jedem Messfenster eine Distanz des zugehörigen Messtupels zu dem Rauschtupel ermitteln, und i) aus der Vielzahl der Messfenster die Messfenster als Fehlersignalfenster bestimmen, deren zugehöriges Messtupel jeweils eine Distanz zum Rauschtupel aufweisen, die größer als ein erster, vorbestimmter Grenzwert ist, so dass jedes Fehlersignalfenster einen Signalfehler des Messsignals repräsentiert.

Wie aus der Figur 4 zu erkennen ist, schließt die Untersuchungsphase 18 an die Initialisierungsphase 12 an. Mittels der Prozessoreinheit 10 werden also in der Initialisierungsphase 12 die Schritte b) bis e) ausgeführt. Danach erfolgt die Ausführung der Schritte f) bis i) in der Untersuchungsphase 18. Darauf hin kann wieder die Initialisierungsphase 12 beginnen. Grundsätzlich ist es jedoch auch möglich, dass die Untersuchungsphase 18 mehrfach nach der Initialisierungsphase 12 ausgeführt wird, bevor wieder mit einer neuen Initialisierungsphase 12 gestartet wird. Für das Verfahren wird auf die vorhergehenden, bevorzugten Erläuterungen, vorteilhaften Merkmale, technischen Effekte und/oder Vorteile in analoger Weise Bezug genommen.

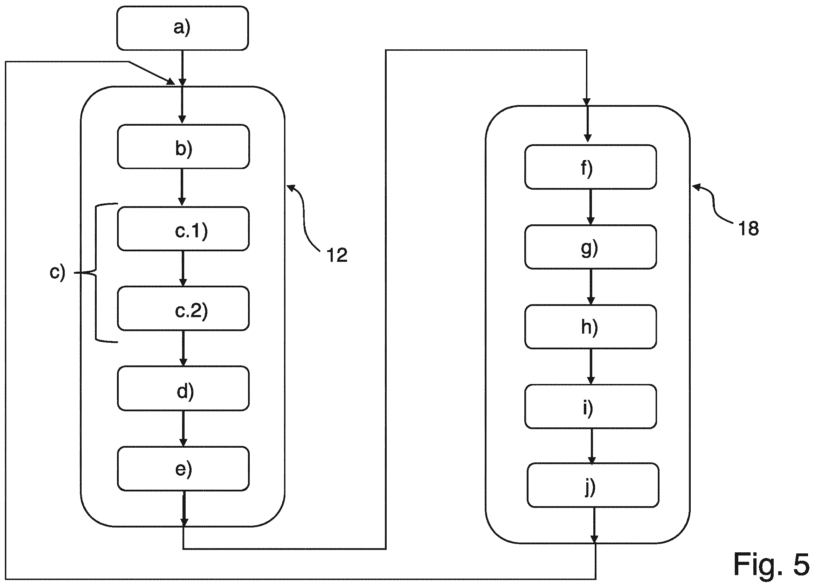

In der Fig. 5 ist eine weitere, vorteilhafte Ausgestaltung des Verfahrens dargestellt, wobei auf die Erläuterungen zu den vorherigen Schritte a) bis i) Bezug genommen wird. Das Verfahren aus Fig. 5 umfasst in Schritt c) die Teilschritte c.1) und c.2), die von der Prozessoreinheit 10 ausgeführt werden: c.1) zu jedem Initialisierungsfenster wird die zugehörige Anzahl der Nulldurchgänge und/oder eine zugehörige Signalenergie des von dem jeweiligen Initialisierungsfenster repräsentierten Teils des Messsignals ermittelt, und c.2) aus den M Initialisierungsfenstern wird eine Anzahl von K Initialisierungsfenstern mit den meisten Nulldurchgängen und/oder mit der kleinsten Signalenergie als Rauschfenster bestimmt.

Darüber hinaus ist umfasst in Fig. 5 dargestellte Verfahren außerdem den Schritt j) der Untersuchungsphase 18, der mittels der Prozessoreinheit 10 ausgeführt wird. Gemäß Schritt j) wird jedes Fehlersignalfenster mittels eines vorbestimmten Modells N-ter Ordnung analysiert und die zugehörigen Koeffizienten ermittelt, die ein dem jeweiligen Fehlersignalfenster zugeordnetes Fehlertupel bilden, wobei N eine ganze Zahl von mindestens 6, vorzugsweise 8 ist.

Ergänzend sei darauf hingewiesen, dass "aufweisend" keine anderen Elemente oder Schritte ausschließt und "ein" oder "eine" keine Vielzahl ausschließt. Ferner sei darauf hingewiesen, dass Merkmale, die mit Verweis auf eines der obigen Ausführungsbeispiele beschrieben worden sind, auch in Kombination mit anderen Merkmalen anderer oben beschriebener Ausführungsbeispiele verwendet werden können. Bezugszeichen in den Ansprüchen sind nicht als Einschränkung anzusehen.

BEZUGSZEICHENLISTE

a1 erster Koeffizient
a2 zweiter Koeffizient
D Distanz
G Grenzwert

2 Vorrichtung
4 Eingangssignalschnittstelle
6 Anschlussstelle
8 Betriebsmittel
10 Prozessoreinheit
12 Initialisierungsphase
14 Initialkoeffiziententupel
16 Rauschtupel
18 Untersuchungsphase
20 Messtupel
22 Anzeigeeinheit
24 Ausgangssignalschnittstelle
26 System
28 Einspeiseschnittstelle
30 Bereitstellungsschnittstelle
32 Sensoreinheit
34 Koeffiziententupel
36 Signalleitung
38 elektrische Leitung
40 Signalfenster einer ersten Fehlergruppe
42 Signalfenster einer zweiten Fehlergruppe

**Patentansprüche**

1. **Vorrichtung (2),** aufweisend:

    eine Eingangssignalschnittstelle (4) zum Empfang eines digitalen Messsignals mit einer Folge von Abtastwerten, das ein an einer Anschlussstelle (6) eines elektrischen Betriebsmittels (8) erfasstes Signal repräsentiert, und eine Prozessoreinheit (10),
    wobei die Prozessoreinheit (10) konfiguriert ist, jedem Abtastwert des Messsignals jeweils ein Signalfenster zuzuordnen, das jeweils aus einem Teil der Folge von Abtastwerten des Messsignals mit dem jeweiligen Abtastwert und einer vorbestimmten Anzahl von zeitlich vorhergehenden Abtastwerten des Messsignals gebildet ist;
    wobei die Prozessoreinheit (10) konfiguriert ist, in einer Initialisierungsphase (12) eine Anzahl von M Signalfenstern als Initialisierungsfenster und aus diesen M Initialisierungsfenstern eine Anzahl von K Rauschfenstern zu bestimmen, jedes Rauschfenster mittels eines vorbestimmten Modells X'ter Ordnung zu analysieren und die zugehörigen Koeffizienten zu ermitteln, die ein dem jeweiligen Rauschfenster zugeordnetes Initialkoeffiziententupel (14) bilden, und aus den Initialkoeffiziententupel (14) der Rauschfenster einen Erwartungswert als Rauschtupel (16) zu ermitteln, wobei X eine gerade Zahl zwischen eins und fünf ist; und
    wobei die Prozessoreinheit (10) konfiguriert ist, in einer Untersuchungsphase (18) eine Vielzahl der Signalfenster als Messfenster zu bestimmen, jedes Messfenster mittels des vorbestimmten Modells X'ter Ordnung zu analysieren und die zugehörigen Koeffizienten zu ermitteln, die ein dem jeweiligen Messfenster zugeordnetes Messtupel (20) bilden, zu jedem Messfenster eine Distanz des zugehörigen Messtupels (20) zu dem Rauschtupel (16) zu ermitteln, und aus der Vielzahl der Messfenster die Messfenster als Fehlersignalfenster zu bestimmen, deren zugehöriges Messtupel (20) jeweils eine Distanz zum Rauschtupel (16) aufweisen, die größer als ein erster, vorbestimmter Grenzwert G ist, so dass jedes Fehlersignalfenster einen Signalfehler des Messsignals repräsentiert.

2. Vorrichtung (2) nach dem vorhergehenden Anspruch, **dadurch gekennzeichnet, dass** die Prozessoreinheit (10) konfiguriert ist, zu jedem Initialisierungsfenster die zugehörige Anzahl der Nulldurchgänge und/oder die zugehörige Signalenergie des von dem jeweiligen Initialisierungsfenster repräsentierten Teils des Messsignals zu ermitteln, und wobei die Prozessoreinheit (10) außerdem konfiguriert ist, aus den Initialisierungsfenstern die Anzahl von K Initialisierungsfenstern mit den meisten Nulldurchgängen und/oder mit der kleinsten Signalenergie als die Rauschfenster zu bestimmen.

3. Vorrichtung (2) nach einem der vorhergehenden Ansprüche, **dadurch gekennzeichnet, dass** das Modell X'ter Ordnung als ein LPC-Modell X'ter Ordnung ausgebildet ist.

4. Vorrichtung (2) nach einem der vorhergehenden Ansprüche, **dadurch gekennzeichnet, dass** M eine ganze Zahl von mindestens 100, vorzugsweise mindestens 10000 ist, und wobei K eine ganze Zahl ist, die kleiner als M ist.

5. Vorrichtung (2) nach einem der vorhergehenden Ansprüche, **dadurch gekennzeichnet, dass** jede Initialisierungsphase (12) maximal 0,1 Sekunden, vorzugsweise maximal 0,05 Sekunden dauert.

6. Vorrichtung (2) nach einem der vorhergehenden Ansprüche, **dadurch gekennzeichnet, dass** die Prozessoreinheit (10) konfiguriert ist, jedes Fehlersignalfenster mittels eines vorbestimmten Modells N-ter Ordnung zu analysieren und die zugehörigen Koeffizienten zu ermitteln, die ein dem jeweiligen Fehlersignalfenster zugeordnetes Fehlertupel bilden, wobei N eine ganze Zahl von mindestens 6, vorzugsweise 8 ist.

7. Vorrichtung (2) nach dem vorhergehenden Anspruch, **dadurch gekennzeichnet, dass** die Prozessoreinheit (10) konfiguriert ist, die Fehlertupel in mehrere Fehlergruppen aufzuteilen, sodass die Fehlertupel der gleichen Fehlergruppe untereinander jeweils einen Abstand aufweisen, der kleiner als ein zweiter, vorbestimmter Grenzwert G ist, sodass alle Fehlersignalfenster, die durch ihre zugehörigen Fehlertupel der jeweils gleichen Fehlergruppe zugeordnet sind, den gleichen Signalfehler repräsentieren.

8. Vorrichtung (2) nach einem der vorhergehenden Ansprüche 1 bis 6, **dadurch gekennzeichnet, dass** die Prozessoreinheit (10) konfiguriert ist, die Fehlersignalfenster in mehrere Fehlergruppen aufzuteilen, so dass die Fehlertupel der Fehlersignalfenster der gleichen Fehlergruppe untereinander jeweils einen Abstand aufweisen, der kleiner als ein zweiter, vorbestimmter Grenzwert G ist, so dass alle Fehlersignalfenster der jeweils gleichen Fehlergruppe den gleichen Signalfehler repräsentieren.

9. Vorrichtung (2) nach einem der vorhergehenden Ansprüche 7 bis 8, **dadurch gekennzeichnet, dass** die Prozessoreinheit (10) konfiguriert ist, eine Anzahl von unterschiedlichen Fehlern in dem Betriebsmittel (8) basierend auf der Anzahl der Fehlergruppen zu ermitteln.

10. Vorrichtung (2) nach einem der vorhergehenden Ansprüche 7 bis 9, **dadurch gekennzeichnet, dass** die Prozessoreinheit (10) konfiguriert ist, ein Bildsignal zu erzeugen, das das Messsignal als Signalgraph repräsentiert, und wobei die Prozessoreinheit (10) konfiguriert ist, die Teile des Signalgraphs optisch gleich zu indizieren, die auf Abtastwerten des Messsignals basieren, die Fehlersignalfenstern der gleichen Fehlergruppe zugeordnet sind.

11. Vorrichtung (2) nach dem vorhergehenden Anspruch, **dadurch gekennzeichnet, dass** die Vorrichtung (2) eine Anzeigeeinheit (22) aufweist, wobei die Prozessoreinheit (10) konfiguriert ist, die Anzeigeeinheit (22) derart zu steuern, sodass die Anzeigeeinheit (22) ein Bild basierend auf dem Bildsignal darstellt, sodass das Bild den Signalgraph optisch wiedergibt.

12. Vorrichtung (2) nach einem der vorhergehenden Ansprüche, **dadurch gekennzeichnet, dass** die Prozessoreinheit (10) konfiguriert ist, die Initialisierungsphase (12) mehrfach auszuführen, sodass das Rauschtupel (16) mit jeder Initialisierungsphase (12) neu ermittelt wird.

13. Vorrichtung (2) nach dem vorhergehenden Anspruch, **dadurch gekennzeichnet, dass** die Prozessoreinheit (10) konfiguriert ist, nach jeder Initialisierungsphase (12) mindestens eine Untersuchungsphase (18) auszuführen.

14. **System** (26) zur Energieübertragung, wobei das System (26) aufweist:

ein Betriebsmittel (8) zur Übertragung eines elektrischen Energiesignals von einer Einspeiseschnittstelle (28) des Betriebsmittels (8) zu einer Bereitstellungsschnittstelle (30) des Betriebsmittels (8),
eine Sensoreinheit (32), und
eine Vorrichtung (2) nach einem der vorhergehenden Ansprüche,
wobei die Sensoreinheit (32) an einer Anschlussstelle (6) des Betriebsmittels (8) zwischen der Einspeiseschnittstelle (28) und der Bereitstellungsschnittstelle (30) angeordnet ist,

wobei die Sensoreinheit (32) zur Erfassung des elektrischen Energiesignals und zur Erzeugung eines digitalen Messsignals ausgebildet ist, das das an der Anschlussstelle (6) erfasste Energiesignal repräsentiert, und wobei die Sensoreinheit (32) mit der Signalschnittstelle der Vorrichtung (2) gekoppelt ist, um das Messsignal an die Signalschnittstelle zu übertragen.

15. System (26) nach dem vorhergehenden Anspruch, **dadurch gekennzeichnet, dass** das Betriebsmittel (8) als eine Hochspannungsleitung, Transformator, rotierende elektrische Maschine, gasisolierte Leitungen oder gasisolierte Schaltanlage ausgebildet ist.

16. **Verfahren** zum Betrieb einer Vorrichtung (2) mit einer Eingangssignalschnittstelle (4) zum Empfang eines digitalen Messsignals mit einer Folge von Abtastwerten, das ein an einer Anschlussstelle (6) eines elektrischen Betriebsmittels (8) erfasstes Signal repräsentiert,

wobei das Verfahren zumindest den folgenden Schritt umfasst:

a) Mittels der Prozessoreinheit (10) jedem Abtastwert des Messsignals jeweils ein Signalfenster zuordnen, das jeweils aus einem Teil der Folge von Abtastwerten des Messsignals mit dem jeweiligen Abtastwert und einer vorbestimmten Anzahl von zeitlich vorhergehenden Abtastwerten des Messsignals gebildet ist;

wobei das Verfahren ausgebildet ist, in einer Initialisierungsphase (12) mittels der Prozessoreinheit (10) die folgenden Schritte auszuführen:

b) eine Anzahl von M Signalfenstern als Initialisierungsfenster bestimmen,
c) aus den M Initialisierungsfenstern eine Anzahl von K Initialisierungsfenstern als Rauschfenster bestimmen,
d) jedes Rauschfenster mittels eines vorbestimmten Modells X'ter Ordnung analysieren und die zugehörigen Koeffizienten ermitteln, die ein dem jeweiligen Rauschfenster zugeordnetes Initialkoeffizientientupel (14) bilden, wobei X eine gerade Zahl zwischen eins und fünf ist, und
e) aus dem Initialkoeffizientientupel (14) der Rauschfenster einen Erwartungswert als Rauschtupel (16) ermitteln;

wobei das Verfahren ausgebildet ist, in einer Untersuchungsphase (18) mittels der Prozessoreinheit (10) die folgenden Schritte auszuführen:

f) eine Vielzahl der Signalfenster als Messfenster bestimmen,
g) jedes Messfenster mittels des vorbestimmten Modells X'ter Ordnung analysieren und die zugehörigen Koeffizienten ermitteln, die ein dem jeweiligen Messfenster zugeordnetes Messtupel (20) bilden,
h) zu jedem Messfenster eine Distanz D des zugehörigen Messtupels (20) zu dem Rauschtupel (16) ermitteln, und
i) aus der Vielzahl der Messfenster die Messfenster als Fehlersignalfenster bestimmen, deren zugehöriges Messtupel (20) jeweils eine Distanz D zum Rauschtupel (16) aufweisen, die größer als ein erster, vorbestimmter Grenzwert G ist, so dass jedes Fehlersignalfenster einen Signalfehler des Messsignals repräsentiert.

17. Verfahren nach dem vorhergehenden Anspruch, **dadurch gekennzeichnet, dass** die Initialisierungsphase (12) mehrfach von der Prozessoreinheit (10) ausgeführt wird, vorzugsweise 2 bis 10 Mal pro Sekunde.

18. Verfahren nach einem der vorhergehenden Ansprüche 16 bis 17, **dadurch gekennzeichnet, dass** das Modell X'ter Ordnung ein LPC-Modell X'ter Ordnung ist.

19. Verfahren nach einem der vorhergehenden Ansprüche 16 bis 18, **dadurch gekennzeichnet, dass** Schritt c) die folgenden Teilschritte c.1) und c.2) umfasst:

c.1) zu jedem Initialisierungsfenster die zugehörige Anzahl der Nulldurchgänge des von dem jeweiligen Initialisierungsfenster repräsentierten Teils des Messsignals ermitteln, und/oder zu jedem Initialisierungsfenster die zugehörige Signalenergie des von dem jeweiligen Initialisierungsfenster repräsentierten Teils des Messsignals ermitteln, und
c.2) aus den M Initialisierungsfenstern eine Anzahl von K Initialisierungsfenstern mit den meisten Nulldurchgängen als Rauschfenster bestimmen, und/oder
aus den M Initialisierungsfenstern eine Anzahl von K Initialisierungsfenstern mit der kleinsten Signalenergie als Rauschfenster bestimmen.

20. Verfahren nach einem der vorhergehenden Ansprüche 16 bis 19, **dadurch gekennzeichnet, dass** das Verfahren ausgebildet ist, in der Untersuchungsphase (18) mittels der Prozessoreinheit (10) außerdem den folgenden Schritt auszuführen:

j) jedes Fehlersignalfenster mittels eines vorbestimmten Modells N-ter Ordnung analysieren und die zugehörigen Koeffizienten ermitteln, die ein dem jeweiligen Fehlersignalfenster zugeordnetes Fehlertupel bilden, wobei N eine ganze Zahl von mindestens 6, vorzugsweise 8 ist.

21. Verfahren nach dem vorhergehenden Anspruch, **dadurch gekennzeichnet, dass** das Verfahren ausgebildet ist, in der Untersuchungsphase (18) mittels der Prozessoreinheit (10) außerdem den folgenden Schritt auszuführen:

k) die Fehlertupel in mehrere Fehlergruppen aufteilen, so dass die Fehlertupel der gleichen Fehlergruppe untereinander jeweils einen Abstand aufweisen, der kleiner als ein zweiter, vorbestimmter Grenzwert G ist, sodass alle Fehlersignalfenster, die durch ihre zugehörigen Fehlertupel der jeweils gleichen Fehlergruppe zugeordnet sind, den gleichen Signalfehler repräsentieren.

## Claims

1. A **device (2),** having:

   an input signal interface (4) for receiving a digital measurement signal, containing a sequence of samples, that represents a signal detected at a connection point (6) of electrical equipment (8), and
   a processor unit (10),
   wherein the processor unit (10) is configured to assign each sample of the measurement signal a respective signal window formed from a respective portion of the sequence of samples of the measurement signal containing the respective sample and a predetermined number of temporally preceding samples of the measurement signal;
   wherein the processor unit (10) is configured so as, in an initialization phase (12), to determine a number of M signal windows as initialization windows and from these M initialization windows a number of K noise windows, to analyze each noise window by means of a predetermined Xth-order model and to ascertain the associated coefficients that form an initial coefficient tuple (14) assigned to the respective noise window, and to ascertain an expected value as a noise tuple (16) from the initial coefficient tuples (14) of the noise windows, X being an even number between one and five; and
   wherein the processor unit (10) is configured so as, in an examination phase (18), to determine a plurality of the signal windows as measurement windows, to analyze each measurement window by means of the predetermined Xth-order model and to ascertain the associated coefficients that form a measurement tuple (20) assigned to the respective measurement window, to ascertain a distance of the associated measurement tuple (20) from the noise tuple (16) for each measurement window, and to determine from the plurality of measurement windows the measurement windows whose associated measurement tuple (20) is at a respective distance from the noise tuple (16) that is greater than a first, predetermined limit value G as error signal windows, with the result that each error signal window represents a signal error of the measurement signal.

2. The device (2) as claimed in the preceding claim, **characterized in that** the processor unit (10) is configured to ascertain for each initialization window the associated number of zero crossings and/or the associated signal energy in the portion of the measurement signal that is represented by the respective initialization window, and wherein the processor unit (10) is also configured to determine from the initialization windows the number of K initialization windows containing the most zero crossings and/or containing the lowest signal energy as the noise windows.

3. The device (2) as claimed in either of the preceding claims, **characterized in that** the Xth-order model is in the form of an Xth-order LPC model.

4. The device (2) as claimed in one of the preceding claims, **characterized in that** M is an integer of at least 100, preferably at least 10 000, and wherein K is an integer that is less than M.

5. The device (2) as claimed in one of the preceding claims, **characterized in that** each initialization phase (12) lasts a maximum of 0.1 seconds, preferably a maximum of 0.05 seconds.

6. The device (2) as claimed in one of the preceding claims, **characterized in that** the processor unit (10) is configured to analyze each error signal window by means of a predetermined Nth-order model and to ascertain the associated coefficients that form a fault tuple assigned to the respective error signal window, N being an integer of at least 6, preferably 8.

7. The device (2) as claimed in the preceding claim, **characterized in that** the processor unit (10) is configured to divide the fault tuples into multiple fault groups, with the result that the fault tuples in the same fault group are each at an interval from one another that is less than a second, predetermined limit value G, with the result that all error signal windows that are assigned to the same respective fault group by way of their associated fault tuples represent the same signal error.

8. The device (2) as claimed in one of preceding claims 1 to 6, **characterized in that** the processor unit (10) is configured to divide the error signal windows into multiple fault groups, with the result that the fault tuples of the error signal windows in the same fault group are each at an interval from one another that is less than a second, predetermined limit value G, with the result that all error signal windows in the same respective fault group represent the same signal error.

9. The device (2) as claimed in either of preceding claims 7 to 8, **characterized in that** the processor unit (10) is configured to ascertain a number of different faults in the equipment (8) on the basis of the number of fault groups.

10. The device (2) as claimed in one of preceding claims 7 to 9, **characterized in that** the processor unit (10) is configured to generate an image signal that represents the measurement signal as a signal graph, and wherein the processor unit (10) is configured to index the portions of the signal graph that are based on samples of the measurement signal that are assigned to error signal windows in the same fault group in the same visual manner.

11. The device (2) as claimed in the preceding claim, **characterized in that** the device (2) has a display unit (22), wherein the processor unit (10) is configured to control the display unit (22) in such a way that the display unit (22) shows an image on the basis of the image signal, with the result that the image visually reproduces the signal graph.

12. The device (2) as claimed in one of the preceding claims, **characterized in that** the processor unit (10) is configured to execute the initialization phase (12) repeatedly, with the result that the noise tuple (16) is re-ascertained with each initialization phase (12).

13. The device (2) as claimed in the preceding claim, **characterized in that** the processor unit (10) is configured to execute at least one examination phase (18) after each initialization phase (12).

14. A **system** (26) for power transmission, the system (26) having:

   equipment (8) for transmitting an electric power signal from a supply interface (28) of the equipment (8) to a delivery interface (30) of the equipment (8),
   a sensor unit (32), and
   a device (2) as claimed in one of the preceding claims,
   wherein the sensor unit (32) is arranged at a connection point (6) of the equipment (8) between the supply interface (28) and the delivery interface (30),
   wherein the sensor unit (32) is designed to detect the electric power signal and to generate a digital measurement signal that represents the power signal detected at the connection point (6), and
   wherein the sensor unit (32) is coupled to the signal interface of the device (2) in order to transmit the measurement signal to the signal interface.

15. The system (26) as claimed in the preceding claim, **characterized in that** the equipment (8) is in the form of a high-voltage line, transformer, rotating electrical machine, gas-insulated lines or gas-insulated switchgear.

16. A **method** for operating a device (2) having an input signal interface (4) for receiving a digital measurement signal, containing a sequence of samples, that represents a signal detected at a connection point (6) of electrical equipment (8),

   the method comprising at least the following step:

a) using the processor unit (10) to assign each sample of the measurement signal a respective signal window formed from a respective portion of the sequence of samples of the measurement signal containing the respective sample and a predetermined number of temporally preceding samples of the measurement signal;

wherein the method is designed to carry out the following steps in an initialization phase (12) by means of the processor unit (10):

b) determining a number of M signal windows as initialization windows,
c) determining from the M initialization windows a number of K initialization windows as noise windows,
d) analyzing each noise window by means of a predetermined Xth-order model and ascertaining the associated coefficients that form an initial coefficient tuple (14) assigned to the respective noise window, X being an even number between one and five, and
e) ascertaining an expected value as a noise tuple (16) from the initial coefficient tuple (14) of the noise windows;

wherein the method is designed to carry out the following steps in an examination phase (18) by means of the processor unit (10):

f) determining a plurality of the signal windows as measurement windows,
g) analyzing each measurement window by means of the predetermined Xth-order model and ascertaining the associated coefficients that form a measurement tuple (20) assigned to the respective measurement window,
h) ascertaining a distance D of the associated measurement tuple (20) from the noise tuple (16) for each measurement window, and
i) determining from the plurality of measurement windows the measurement windows whose associated measurement tuple (20) is at a respective distance D from the noise tuple (16) that is greater than a first, predetermined limit value G as error signal windows, with the result that each error signal window represents a signal error of the measurement signal.

17. The method as claimed in the preceding claim, **characterized in that** the initialization phase (12) is executed repeatedly by the processor unit (10), preferably 2 to 10 times per second.

18. The method as claimed in either of preceding claims 16 to 17, **characterized in that** the Xth-order model is an Xth-order LPC model.

19. The method as claimed in one of preceding claims 16 to 18, **characterized in that** step c) comprises the following substeps c.1) and c.2):

c.1) ascertaining for each initialization window the associated number of zero crossings in the portion of the measurement signal that is represented by the respective initialization window, and/or
ascertaining for each initialization window the associated signal energy in the portion of the measurement signal that is represented by the respective initialization window, and
c.2) determining from the M initialization windows a number of K initialization windows containing the most zero crossings as noise windows, and/or
determining from the M initialization windows a number of K initialization windows containing the lowest signal energy as noise windows.

20. The method as claimed in one of preceding claims 16 to 19, **characterized in that** the method is designed to also carry out the following step in the examination phase (18) by means of the processor unit (10):
j) analyzing each error signal window by means of a predetermined Nth-order model and ascertaining the associated coefficients that form a fault tuple assigned to the respective error signal window, N being an integer of at least 6, preferably 8.

21. The method as claimed in the preceding claim, **characterized in that** the method is designed to also carry out the following step in the examination phase (18) by means of the processor unit (10):
k) dividing the fault tuples into multiple fault groups, with the result that the fault tuples in the same fault group are each at an interval from one another that is less than a second, predetermined limit value G, with the result that all error signal windows that are assigned to the same respective fault group by way of their associated fault tuples represent the same signal error.

**Revendications**

1. Dispositif (2), présentant :

une interface de signal d'entrée (4) pour recevoir un signal de mesure numérique avec une série de valeurs de balayage, qui représente un signal détecté à un point de branchement (6) d'un équipement d'exploitation électrique (8), et
une unité de traitement (10),
dans lequel l'unité de traitement (10) est configurée pour attribuer à chaque valeur de balayage du signal de mesure respectivement une fenêtre de signal qui est formée respectivement d'une partie de la série de valeurs de balayage du signal de mesure avec la valeur de balayage respective et d'un nombre prédéterminé de valeurs de balayage antérieures dans le temps du signal de mesure ;
dans lequel l'unité de traitement (10) est configurée pour déterminer dans une phase d'initialisation (12) un nombre de M fenêtres de signal en tant que fenêtres d'initialisation et pour déterminer à partir de ces M fenêtres d'initialisation un nombre de K fenêtres de bruit, pour analyser chaque fenêtre de bruit au moyen d'un modèle prédéterminé du X-ième ordre, et pour établir les coefficients associés qui forment un tuple de coefficients initiaux (14) attribué à la fenêtre de bruit respective, et pour établir à partir du tuple de coefficients initiaux (14) des fenêtres de bruit une valeur attendue en tant que tuple de bruit (16), X étant un nombre pair entre un et cinq ; et
dans lequel l'unité de traitement (10) est configurée pour déterminer dans une phase d'examen (18) une pluralité des fenêtres de signal en tant fenêtres de mesure, pour analyser chaque fenêtre de mesure au moyen du modèle prédéterminé du X-ième ordre et établir les coefficients associés qui forment un tuple de mesure (20) attribué à la fenêtre de mesure respective, pour établir pour chaque fenêtre de mesure une distance du tuple de mesure (20) attribué au tuple de bruit (16), et pour déterminer à partir de la pluralité des fenêtres de mesure les fenêtres de mesure en tant que fenêtres de signal d'erreur dont le tuple de mesure (20) associé présente respectivement une distance par rapport au tuple de bruit (16) qui est supérieure à une première valeur limite G prédéterminée de sorte que chaque fenêtre de signal d'erreur représente une erreur de signal du signal de mesure.

2. Dispositif (2) selon la revendication précédente, **caractérisé en ce que** l'unité de traitement (10) est configurée pour établir, pour chaque fenêtre d'initialisation, le nombre associé des passages par zéro et/ou l'énergie de signal associée de la partie du signal de mesure représentée par la fenêtre d'initialisation respective, et dans lequel l'unité de traitement (10) est en outre configurée pour déterminer à partir des fenêtres d'initialisation le nombre de K fenêtres d'initialisation avec le plus grand nombre de passages par zéro et/ou la plus petite énergie de signal en tant que fenêtres de bruit.

3. Dispositif (2) selon l'une quelconque des revendications précédentes, **caractérisé en ce que** le modèle du X-ième ordre est réalisé en tant que modèle LPC du X-ième ordre.

4. Dispositif (2) selon l'une quelconque des revendications précédentes, **caractérisé en ce que** M est un nombre entier d'au moins 100, de préférence d'au moins 10 000, et dans lequel K est un nombre entier qui est inférieur à M.

5. Dispositif (2) selon l'une quelconque des revendications précédentes, **caractérisé en ce que** chaque phase d'initialisation (12) dure au maximum 0,1 seconde, de préférence au maximum 0,05 seconde.

6. Dispositif (2) selon l'une quelconque des revendications précédentes, **caractérisé en ce que** l'unité de traitement (10) est configurée pour analyser chaque fenêtre de signal d'erreur au moyen d'un modèle prédéterminé du n-ième ordre et établir les coefficients associés qui forment un tuple d'erreur attribué à la fenêtre de signal d'erreur respective, N étant un nombre entier d'au moins 6, de préférence de 8.

7. Dispositif (2) selon la revendication précédente, **caractérisé en ce que** l'unité de traitement (10) est configurée pour répartir les tuples d'erreur en plusieurs groupes d'erreurs de sorte que les tuples d'erreur du même groupe d'erreurs présentent entre eux respectivement une distance qui est inférieure à une deuxième valeur limite G prédéterminée de sorte que toutes les fenêtres de signal d'erreur qui sont par leurs tuples d'erreur associés attribués au même groupe d'erreurs respectivement représentent la même erreur de signal.

**8.** Dispositif (2) selon l'une quelconque des revendications précédentes 1 à 6, **caractérisé en ce que** l'unité de traitement (10) est configurée pour répartir les fenêtres de signal d'erreur en plusieurs groupes d'erreurs de sorte que les tuples d'erreur des fenêtres de signal d'erreur du même groupe d'erreurs présentent entre eux respectivement une distance qui est inférieure à une deuxième valeur limite G prédéterminée de sorte que toutes les fenêtres de signal d'erreur du même groupe d'erreurs respectivement représentent la même erreur de signal.

**9.** Dispositif (2) selon l'une quelconque des revendications précédentes 7 à 8, **caractérisé en ce que** l'unité de traitement (10) est configurée pour établir un nombre de différentes erreurs dans l'équipement d'exploitation (8) sur la base du nombre des groupes d'erreurs.

**10.** Dispositif (2) selon l'une quelconque des revendications précédentes 7 à 9, **caractérisé en ce que** l'unité de traitement (10) est configurée pour générer un signal d'image qui représente le signal de mesure sous forme de graphe de signal, et dans lequel l'unité de traitement (10) est configurée pour indexer optiquement de la même manière les parties du graphe de signal qui sont basées sur des valeurs de balayage du signal de mesure qui sont attribuées à des fenêtres de signal d'erreur du même groupe d'erreurs.

**11.** Dispositif (2) selon la revendication précédente, **caractérisé en ce que** le dispositif (2) présente une unité d'affichage (22), dans lequel l'unité de traitement (10) est configurée pour commander l'unité d'affichage (22) de telle sorte que l'unité d'affichage (22) représente une image sur la base du signal d'image de sorte que l'image reproduit optiquement le graphe de signal.

**12.** Dispositif (2) selon l'une quelconque des revendications précédentes, **caractérisé en ce que** l'unité de traitement (10) est configurée pour exécuter plusieurs fois la phase d'initialisation (12) de sorte que le tuple de bruit (16) est établi à nouveau à chaque phase d'initialisation (12).

**13.** Dispositif (2) selon la revendication précédente, **caractérisé en ce que** l'unité de traitement (10) est configurée pour exécuter au moins une phase d'examen (18) après chaque phase d'initialisation (12).

**14.** Système (26) de transmission d'énergie, le système (26) présentant :

un équipement d'exploitation (8) pour transmettre un signal d'énergie électrique d'une interface d'alimentation (28) de l'équipement d'exploitation (8) à une interface de distribution (30) de l'équipement d'exploitation (8), une unité de capteur (32), et un dispositif (2) selon l'une quelconque des revendications précédentes, dans lequel l'unité de capteur (32) est disposée à un point de branchement (6) de l'équipement d'exploitation (8) entre l'interface d'alimentation (28) et l'interface de distribution (30), dans lequel l'unité de capteur (32) est réalisée pour détecter le signal d'énergie électrique et pour générer un signal de mesure numérique qui représente le signal d'énergie détecté au point de branchement (6), et dans lequel l'unité de capteur (32) est couplée à l'interface de signal du dispositif (2) pour transmettre le signal de mesure à l'interface de signal.

**15.** Système (26) selon la revendication précédente, **caractérisé en ce que** l'équipement d'exploitation (8) est réalisé sous forme de ligne haute tension, de transformateur, de machine électrique rotative, de lignes à isolation gazeuse ou d'appareillage de commutation à isolation gazeuse.

**16.** Procédé permettant de faire fonctionner un dispositif (2) pourvu d'une interface de signal d'entrée (4) pour recevoir un signal de mesure numérique avec une série de valeurs de balayage qui représente un signal détecté à un point de branchement (6) d'un équipement d'exploitation électrique (8),

dans lequel le procédé comprend au moins l'étape suivante consistant à :

a) attribuer au moyen de l'unité de traitement (10) à chaque valeur de balayage du signal de mesure respectivement une fenêtre de signal qui est formée respectivement d'une partie de la série de valeurs de balayage du signal de mesure avec la valeur de balayage respective et d'un nombre prédéterminé de valeurs de balayage antérieures dans le temps du signal de mesure ;

dans lequel le procédé est réalisé pour exécuter dans une phase d'initialisation (12) au moyen de l'unité de traitement (10) les étapes suivantes consistant à :

b) déterminer un nombre de M fenêtres de signal en tant que fenêtres d'initialisation,

c) déterminer à partir des M fenêtres d'initialisation un nombre de K fenêtres d'initialisation en tant que fenêtres de bruit,

d) analyser chaque fenêtre de bruit au moyen d'un modèle du X-ième ordre prédéterminé et établir les coefficients associés qui forment un tuple de coefficients initiaux (14) attribué à la fenêtre de bruit respective, X étant un nombre pair entre un et cinq, et

e) établir à partir du tuple de coefficients initiaux (14) des fenêtres de bruit une valeur attendue en tant que tuple de bruit (16) ;

dans lequel le procédé est réalisé pour exécuter dans une phase d'examen (18) au moyen de l'unité de traitement (10) les étapes suivantes consistant à :

f) déterminer une pluralité des fenêtres de signal en tant que fenêtres de mesure,

g) analyser chaque fenêtre de mesure au moyen du modèle du X-ième ordre prédéterminé et établir les coefficients associés qui forment un tuple de mesure (20) attribué à la fenêtre de mesure respective,

h) établir pour chaque fenêtre de mesure une distance D du tuple de mesure (20) associé par rapport au tuple de bruit (16), et

i) déterminer, à partir de la pluralité des fenêtres de mesure, les fenêtres de mesure en tant que fenêtres de signal d'erreur dont le tuple de mesure (20) présente respectivement une distance D par rapport au tuple de bruit (16) qui est supérieure à une première valeur limite G prédéterminée de sorte que chaque fenêtre de signal d'erreur représente une erreur de signal du signal de mesure.

17. Procédé selon la revendication précédente, **caractérisé en ce que** la phase d'initialisation (12) est exécutée plusieurs fois, de préférence de 2 à 10 fois par seconde, par l'unité de traitement (10).

18. Procédé selon l'une quelconque des revendications précédentes 16 à 17, **caractérisé en ce que** le modèle du X-ième ordre est un modèle LPC du X-ième ordre.

19. Procédé selon l'une quelconque des revendications précédentes 16 à 18, **caractérisé en ce que** l'étape c) comprend les sous-étapes c1) et c2) suivantes :

c1) établir pour chaque fenêtre d'initialisation le nombre associé des passages par zéro de la partie du signal de mesure représentée par la fenêtre d'initialisation respective, et/ou

établir pour chaque fenêtre d'initialisation l'énergie de signal associée de la partie du signal de mesure représentée par la fenêtre d'initialisation respective, et

c2) déterminer, à partir des M fenêtres d'initialisation, un nombre de K fenêtres d'initialisation avec le plus grand nombre de passages par zéro en tant que fenêtres de bruit, et/ou

déterminer, à partir des M fenêtres d'initialisation, un nombre de K fenêtres d'initialisation avec la plus petite énergie de signal en tant que fenêtres de bruit.

20. Procédé selon l'une quelconque des revendications précédentes 16 à 19, **caractérisé en ce que** le procédé est réalisé pour exécuter dans la phase d'examen (18) au moyen de l'unité de traitement (10) en outre l'étape suivante consistant à :

j) analyser chaque fenêtre de signal d'erreur au moyen d'un modèle du n-ième ordre prédéterminé et établir les coefficients associés qui forment un tuple d'erreur attribué à la fenêtre de signal d'erreur respective, N étant un nombre entier d'au moins 6, de préférence de 8.

21. Procédé selon la revendication précédente, **caractérisé en ce que** le procédé est réalisé pour exécuter dans la phase d'examen (18) au moyen de l'unité de traitement (10) en outre l'étape suivante consistant à :

k) répartir les tuples d'erreur en plusieurs groupes d'erreurs de sorte que les tuples d'erreur du même groupe d'erreurs présentent entre eux respectivement une distance qui est inférieure à une deuxième valeur limite G prédéterminée de sorte que toutes les fenêtres de signal d'erreur qui sont par leurs tuples d'erreur attribuées associés au même groupe d'erreurs respectivement représentent la même erreur de signal.

Fig. 1

Fig. 2

Fig. 3

Fig. 4

Fig. 5

**EP 4 189 407 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 9305077 B
- CN 106160944
- DE 102018126743 B3